(19) Europäisches Patentamt
European Patent Office
Office européen des brevets

(11) **EP 4 679 492 A1**

(12) **EUROPEAN PATENT APPLICATION**
published in accordance with Art. 153(4) EPC

(43) Date of publication:
**14.01.2026 Bulletin 2026/03**

(21) Application number: **24767225.6**

(22) Date of filing: **07.03.2024**

(51) International Patent Classification (IPC):
***H01L 21/304*** *(2006.01)* ***C09J 11/06*** *(2006.01)*
***C09J 183/04*** *(2006.01)* ***C09J 183/05*** *(2006.01)*
***C09J 183/07*** *(2006.01)* ***C09J 201/00*** *(2006.01)*

(52) Cooperative Patent Classification (CPC):
**C09J 11/06; C09J 183/04; C09J 201/00; H01L 21/304**

(86) International application number:
**PCT/JP2024/008855**

(87) International publication number:
**WO 2024/185859 (12.09.2024 Gazette 2024/37)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **07.03.2023 JP 2023035081**

(71) Applicant: **SHIN-ETSU CHEMICAL CO., LTD.**
**Tokyo 1000005 (JP)**

(72) Inventors:
- **MUTO Mitsuo**
  **Annaka-shi, Gunma 379-0224 (JP)**
- **TAGAMI Shohei**
  **Annaka-shi, Gunma 379-0224 (JP)**
- **SUGO Michihiro**
  **Annaka-shi, Gunma 379-0224 (JP)**

(74) Representative: **Schicker, Silvia**
**Wuesthoff & Wuesthoff**
**Patentanwälte und Rechtsanwalt PartG mbB**
**Schweigerstraße 2**
**81541 München (DE)**

(54) **TEMPORARY ADHESIVE FOR WAFER PROCESSING, WAFER PROCESSED BODY, AND METHOD FOR MANUFACTURING THIN WAFER**

(57) The present invention is a temporary adhesive material for wafer processing, used for temporarily bonding a support and a wafer having a circuit-forming surface on a front side and a backside to be processed, including a composite temporary adhesive material layer having a two-layered structure that includes a first temporary adhesive layer including a thermoplastic resin layer (A) capable of peelably adhering to the front side of the wafer, and a second temporary adhesive layer including a thermosetting siloxane polymer layer (B) laminated on the first temporary adhesive layer. Accordingly, the present invention provides a temporary adhesive material for wafer processing that has, irrespective of the surface treatment of the wafer substrate, stable wafer processability, excellent peelability of the support, and easy cleaning removability of the temporary adhesive material layer after peeling of the support, can be formed with uniform film thickness even on a substrate with a large step height, exhibits high process compatibility with TSV formation and wafer backside wiring processes, and furthermore exhibits excellent resistance to wafer thermal processes such as chemical vapor deposition (CVD), thereby enhancing the productivity of thin wafers.

[FIG. 1]

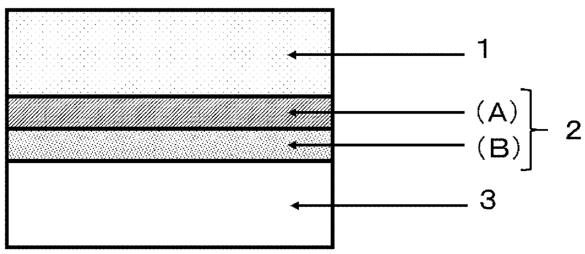


EP 4 679 492 A1

## Description

### TECHNICAL FIELD

The present invention relates to a temporary adhesive material for wafer processing, a wafer processing body, and a method for producing a thin wafer.

### BACKGROUND ART

Three-dimensional semiconductor packaging has become essential to achieve even higher density and larger capacity. Three-dimensional packaging technique is a semiconductor fabrication technique that involves thinning a single semiconductor chip and then stacking it in multiple layers while interconnecting them using through-silicon vias (TSVs). To achieve this, it is necessary to have a process of thinning the substrate on which the semiconductor circuit is formed by grinding the non-circuit-forming surface (also referred to as "backside"), and forming electrodes that includes TSVs on the backside. Traditionally, in the backside grinding process of a silicon substrate, a backside protective tape is applied to the opposite side of the grinding surface to prevent wafer damage during grinding. However, this tape uses an organic resin film as the support base material and, while flexible, it lacks sufficient strength and heat resistance, making it unsuitable for use in a TSV formation process or a wiring layer formation process on the backside.

Thus, a system has been proposed in which a semiconductor substrate is bonded to a support such as silicon or glass via an adhesive layer, allowing it to sufficiently withstand the backside grinding, and TSV formation and backside electrode formation processes. The key factor in this situation is the adhesive layer that bonds the substrate and the support. The adhesive layer is required to be capable of bonding the substrate and the support without gaps, have sufficient durability to withstand subsequent processes, and further be capable of easily peeling the thin wafer from the support at the end. As such, the peeling is ultimately performed, thus this adhesive layer is referred to as a temporary adhesive layer (or temporary adhesive material layer) herein.

Known temporary adhesive layers and peeling methods thereof so far include a technique where high-intensity light is irradiated onto an adhesive material containing a light-absorbing substance to decompose the adhesive material layer and peel the adhesive material layer from the support (Patent Document 1), and a technique where thermally fusible hydrocarbon-based compounds are used in an adhesive material and bonding and peeling are performed in a heated, molten state (Patent Document 2). The former technique requires expensive apparatus such as lasers, and there are problems such as long processing times per substrate. Although the latter technique is convenient because only heating is needed to control, its thermal stability is insufficient at high temperatures exceeding 200°C, thus its applicability is limited. Furthermore, these temporary adhesive layers are not suitable for forming with uniform film thickness on a substrate with a large step height or for complete adhesion to a support.

The technique that uses a silicone resin as a temporary adhesive material layer has been proposed. In this technique, a substrate is bonded to a support using a thermosetting silicone resin, and when peeling, the substrate is separated from the support by immersing in a solvent that dissolves or decomposes the silicone resin (Patent Document 3). Thus, peeling needs a very long time, making it difficult to apply to the actual manufacturing process. Furthermore, after peeling, a long time is also required to clean the silicone resin left as residue on the substrate, which is also a challenge in terms of cleaning removability. Furthermore, to impart heat resistance and chemical resistance to the substrate, the surface of the substrate may be treated or coated with an oxide film, nitride film, organic resin film or the like in advance. However, depending on the type of chemical modification of such a substrate surface, the adhesion to the silicone resin may vary, leading to problems such as unstable wafer processability and inability to achieve sufficient peelability of the support.

Furthermore, a temporary adhesive material consisting of a three-layer structure of a non-silicone thermoplastic resin layer (A layer), a thermosetting siloxane polymer layer (B layer), and a thermosetting siloxane modified polymer layer (C layer) is conventionally known (Patent Document 4). In application examples of this material, the layer A is first coated onto a substrate, and then the layer B is coated on the layer A. The layer C is lastly coated on a support, and then the substrate in which the layer A and the layer B are laminated in this order from the side closest to the substrate, and the support on which the layer C is laminated are bonded to produce a wafer laminate. In this case, there are challenges related to workability improvements, such as the decreased workability in the production of wafer laminates due to the variety of coating liquids, and the extended time required in the subsequent substrate cleaning process due to the thick remaining of the thermosetting siloxane polymer layer of the layer B on the substrate side during peeling the support.

### CITATION LIST

PATENT LITERATURE

Patent Document 1: JP 2004-64040 A
Patent Document 2: JP 2006-328104 A
Patent Document 3: US 7541264 B
Patent Document 4: JP 2016-122730 A

SUMMARY OF INVENTION

TECHNICAL PROBLEM

The present invention has been made in view of the above problems, and an object of the present invention is to provide a temporary adhesive material for wafer processing that has, irrespective of the surface treatment of the wafer substrate, stable wafer processability, excellent peelability of the support, and easy cleaning removability of the temporary adhesive material layer after peeling of the support, can be formed with uniform film thickness even on a substrate with a large step height, exhibits high process compatibility with TSV formation and wafer backside wiring processes, and furthermore, exhibits excellent resistance to wafer thermal processes such as chemical vapor deposition (CVD), thereby enhancing the productivity of thin wafers, and provide a method for producing a thin wafer and a wafer processing body which use the temporary adhesive material for wafer processing.

SOLUTION TO PROBLEM

To achieve the above objects, the present invention provides a temporary adhesive material for wafer processing, used for temporarily bonding a support and a wafer having a circuit-forming surface on a front side and a backside to be processed, including a composite temporary adhesive material layer having a two-layered structure that includes a first temporary adhesive layer including a thermoplastic resin layer (A) capable of peelably adhering to the front side of the wafer, and a second temporary adhesive layer including a thermosetting siloxane polymer layer (B) laminated on the first temporary adhesive layer.
According to the temporary adhesive material for wafer processing of the present invention, the thermoplastic resin layer is interposed between the thermosetting siloxane polymer layer and the surface of the wafer substrate, thereby stabilizing the adhesion between the wafer substrate and the support, irrespective of the type of treatment applied to the surface of the wafer substrate in advance, which improves the wafer processability and stabilizes the peelability of the support. Furthermore, the temporary adhesive material for wafer processing of the present invention has excellent cleaning removability of residues of the temporary adhesive material after peeling, thereby enhancing the productivity of thin wafers.
In the present invention, it is preferable that the thermosetting siloxane polymer layer (B) is a cured layer of a thermosetting siloxane composition containing

(B-1) organopolysiloxane having two or more alkenyl groups in one molecule in an amount of 100 parts by mass,
(B-2) organohydrogenpolysiloxane containing two or more silicon atom-bonded hydrogen atoms (Si-H groups) in one molecule in an amount such that a molar ratio of the Si-H group in component (B-2) to the alkenyl group in the component (B-1) is 0.3 to 10,
(B-3) non-functional organopolysiloxane in an amount of 0.1 to 200 parts by mass, and
(B-4) a hydrosilylation reaction catalyst in an amount of 0.1 to 5,000 ppm in terms of metal atom amount based on the total mass of the components (B-1), (B-2), and (B-3).

A temporary adhesive material for wafer processing having such a thermosetting siloxane polymer layer (B) exhibits more excellent CVD resistance.
In this case, it is preferable that the thermosetting siloxane composition further contains a hydrosilylation reaction control agent as component (B-5), and an amount of the component (B-5) added is 0.0001 to 50 parts by mass based on the total mass of the components (B-1), (B-2), and (B-3).
With such a temporary adhesive material for wafer processing, the treatment liquid (thermosetting siloxane composition) is less likely to undergo thickening or gelation before curing.
In addition, it is preferable that the non-functional organopolysiloxane as the component (B-3) consists of dimethylpolysiloxane and has a viscosity of 100 to 500,000 mPa·s at 25°C in a 30% by mass toluene solution.
In the temporary adhesive material for wafer processing of the present invention, it is preferable that the

thermosetting siloxane polymer layer (B) has, after curing, a 180° peel strength of 2 gf (0.020 N) or more and 500 gf (4.9 N) or less when tested with a 25 mm-wide test piece against the thermoplastic resin layer (A) at 25°C.

With a temporary adhesive material for wafer processing including a thermosetting siloxane polymer layer (B) having such a peel strength, there is no risk of wafer misalignment during wafer grinding, and peeling of the support becomes easier.

In addition, in the temporary adhesive material for wafer processing of the present invention, it is preferable that the thermosetting siloxane polymer layer (B) has, after curing, a storage modulus of 1,000 Pa or more and 1,000 MPa or less, and more preferably 10,000 Pa or more and 100 MPa or less, at 25°C.

With a temporary adhesive material for wafer processing including a thermosetting siloxane polymer layer (B) having such a storage modulus, there is no risk of wafer misalignment during wafer grinding, and the stability remains even during thermal processes of the wafer.

In the temporary adhesive material for wafer processing of the present invention, it is preferable that the thermoplastic resin layer (A) is a non-silicone resin.

With such a temporary adhesive material for wafer processing, characteristics such as the reduction of wafer warpage during bonding, shortening bonding process time, good peelability between the substrate and the support, and cleaning removability are good.

In the temporary adhesive material for wafer processing of the present invention, it is preferable that the temporary adhesive material is used for temporarily bonding the support and the wafer in which the circuit-forming surface is surface-treated with a material different from a base material of the wafer.

In this way, the temporary adhesive material for wafer processing of the present invention is suitable for temporary bonding of a wafer substrate on which a surface treatment is performed.

The present invention also provides a method for producing a thin wafer, including the steps of:

(a) when bonding a support and a circuit-forming surface of a wafer having the circuit-forming surface on a front side and a non-circuit-forming surface on a backside via the temporary adhesive material for wafer processing described above, forming the thermosetting siloxane polymer layer (B) on the support, and then bonding the obtained support and the wafer in which the thermoplastic resin layer (A) is formed on the circuit-forming surface under vacuum;
(b) thermally curing the polymer layer (B);
(c) grinding or polishing the non-circuit-forming surface of the wafer bonded with the support;
(d) processing the non-circuit-forming surface of the wafer; and
(e) peeling the processed wafer from the support.

The present invention also provides a method for producing a thin wafer, including the steps of:

(a) when bonding a support and a circuit-forming surface of a wafer having the circuit-forming surface on a front side and a non-circuit-forming surface on a backside via the temporary adhesive material for wafer processing described above, first forming the thermoplastic resin layer (A) on the circuit-forming surface of the wafer, subsequently forming the thermosetting siloxane polymer layer (B) on the thermoplastic resin layer (A), and then bonding the support and the obtained wafer under vacuum;
(b) thermally curing the polymer layer (B);
(c) grinding or polishing the non-circuit-forming surface of the wafer bonded with the support;
(d) processing the non-circuit-forming surface of the wafer; and
(e) peeling the processed wafer from the support.

With such production methods of a thin wafer, by using the temporary adhesive material layer including the two-layered structure of the present invention to bond a wafer and a support, it becomes possible to easily produce a thin wafer with a through-electrode structure or a bump connection structure using this temporary adhesive material layer.

The present invention also provides a wafer processing body including: a support; a temporary adhesive material layer formed on the support; and a wafer laminated on the temporary adhesive material layer and having a circuit surface on a front side and a backside to be processed, wherein the temporary adhesive material layer includes a composite temporary adhesive material layer having a two-layered structure that includes a first temporary adhesive layer including a thermoplastic resin layer (A) peelably adhered to the front side of the wafer, and a second temporary adhesive layer including a thermosetting siloxane polymer layer (B) laminated on the first temporary adhesive layer.

With such a wafer processing body, since there is the thermoplastic resin layer (A) between the circuit-bearing wafer and the thermosetting siloxane polymer layer (B), both the processability of the wafer processing body and the peelability of the support from the wafer processing body can be stabilized irrespective of the type of surface treatment applied to the surface of the circuit-bearing wafer in advance, and the temporary adhesive material layer remaining as residues on the circuit-bearing wafer after support peeling has excellent cleaning removability, which allow for a reduction

in the number of steps particularly in the cleaning process and the application of general organic solvents, thereby enhancing the productivity of thin wafers. It is also possible to be formed with uniform film thickness even on a substrate with a large step height, exhibit high process compatibility with TSV formation and wafer backside wiring processes, and further have excellent resistance to thermal processes such as CVD.

In this case, it is preferable that the thermosetting siloxane polymer layer (B) is a cured layer of a thermosetting siloxane composition containing

(B-1) organopolysiloxane having two or more alkenyl groups in one molecule in an amount of 100 parts by mass,
(B-2) organohydrogenpolysiloxane containing two or more silicon atom-bonded hydrogen atoms (Si-H groups) in one molecule in an amount such that a molar ratio of the Si-H group in component (B-2) to the alkenyl group in the component (B-1) is 0.3 to 10,
(B-3) non-functional organopolysiloxane in an amount of 0.1 to 200 parts by mass, and
(B-4) a hydrosilylation reaction catalyst in an amount of 0.1 to 5,000 ppm in terms of metal atom amount based on a total mass of the components (B-1), (B-2), and (B-3).

Such a wafer processing body exhibits more excellent CVD resistance.

In this case, it is preferable that the thermosetting siloxane composition further contains a hydrosilylation reaction control agent as component (B-5), and an amount of the component (B-5) added is 0.0001 to 50 parts by mass based on the total mass of the components (B-1), (B-2), and (B-3).

With such a wafer processing body, the treatment liquid (thermosetting siloxane composition) is less likely to undergo thickening or gelation before curing.

In addition, it is preferable that the non-functional organopolysiloxane of the component (B-3) consists of dimethylpolysiloxane and has a viscosity of 100 to 500,000 mPa·s at 25°C in a 30% by mass toluene solution.

In the present invention, it is also preferable that the thermosetting siloxane polymer layer (B) has, after curing, a 180° peel strength of 2 gf (0.020 N) or more and 500 gf (4.9 N) or less when tested with a 25 mm-wide test piece against the thermoplastic resin layer (A) at 25°C.

With a wafer processing body including a thermosetting siloxane polymer layer (B) having such a peel strength, there is no risk of wafer misalignment during wafer grinding, and peeling of the support becomes easier.

In addition, in the present invention, it is preferable that the thermosetting siloxane polymer layer (B) has, after curing, a storage modulus of 1,000 Pa or more and 1,000 MPa or less at 25°C.

With a wafer processing body including a thermosetting siloxane polymer layer (B) having such a storage modulus, there is no risk of wafer misalignment during wafer grinding, and the stability remains even during thermal processes of the wafer.

It is also preferable that the wafer is a wafer in which the circuit-forming surface is surface-treated with a material different from a base material of the wafer.

In this way, the wafer processing body of the present invention is suitable to be one obtained by temporary bonding a wafer substrate on which a surface treatment is performed.

## ADVANTAGEOUS EFFECTS OF INVENTION

The temporary adhesive material layer in the present invention has a two-layered structure, particularly has a thermoplastic resin layer (A) between a circuit-bearing wafer and a thermosetting siloxane-modified resin layer (B). This ensures that the adhesion to the support and the peelability from the support can be stabilized irrespective of the type of surface treatment on the circuit-bearing wafer, and also improves the cleanability of the residues of the temporary adhesive layer after peeling of the support. Furthermore, in terms of wafer processability, the resin undergoes neither thermal decomposition nor fluidization even at particularly high temperatures of 200°C or higher, has good CVD resistance and can be applied to a wide range of semiconductor film formation processes due to its excellent heat resistance, and can form an adhesive material layer with high film thickness uniformity even for wafers with a step, thereby enabling easy production of fragile thin wafers.

## BRIEF DESCRIPTION OF DRAWING

FIG. 1 is a cross-sectional view showing an example of the wafer processing body of the present invention.

## DESCRIPTION OF EMBODIMENTS

As mentioned above, there is a demand for a temporary adhesive material for wafer processing that has, irrespective of the surface treatment condition of the surface of a circuit-bearing substrate, stable adhesion between the

circuit-bearing substrate and a support as well as peelability of the support, allows for easy cleaning of residues of the temporary adhesive material layer after peeling of the support, can form a temporary adhesive material layer with uniform film thickness even on a substrate with a large step height, exhibits high process compatibility with TSV formation and wafer backside wiring processes, and furthermore exhibits excellent resistance to wafer thermal processes such as CVD.

The present inventors have intensively studied to achieve the above objects and have found a temporary adhesive material for wafer processing that can achieve the above objects by using a composite temporary adhesive material layer having a two-layered system of a thermoplastic temporary adhesive layer (A) containing a thermoplastic resin and a thermosetting temporary adhesive layer (B) containing a thermosetting siloxane polymer in a structure formed in the order of (A) and (B) from the wafer side for bonding the wafer and the support, and can easily produce a thin wafer with a through-electrode structure or a bump connection structure, and a method for producing a thin wafer using the temporary adhesive material for wafer processing.

That is, the present invention is a temporary adhesive material for wafer processing that is characterized in that it is a temporary adhesive material for wafer processing, used for temporarily bonding a support and a wafer having a circuit-forming surface on a front side and a backside to be processed, including a composite temporary adhesive material layer having a two-layered structure that includes a first temporary adhesive layer including a thermoplastic resin layer (A) capable of peelably adhering to the front side of the wafer, and a second temporary adhesive layer including a thermosetting siloxane polymer layer (B) laminated on the first temporary adhesive layer.

Hereinafter, the present invention will be described in detail, but the present invention is not limited to these.

[Temporary Adhesive Material for Wafer Processing]

The temporary adhesive material for wafer processing of the present invention is used to temporarily bond a support and a wafer having a circuit surface on a front side and a backside to be processed. This temporary adhesive material for wafer processing includes a composite temporary adhesive material layer having a two-layered structure that includes a first temporary adhesive layer including a thermoplastic resin layer (A) capable of peelably adhering to the front side of the wafer, and a second temporary adhesive layer including a thermosetting siloxane polymer layer (B) laminated on the first temporary adhesive layer.

Hereinafter, the temporary adhesive material for wafer processing described above is explained while referring to a figure.

FIG. 1 is a cross-sectional view showing an example of the wafer processing body of the present invention. As shown in FIG. 1, the wafer processing body of the present invention includes a wafer (device wafer) 1 having a circuit surface on a front side and a backside to be processed, a support 3 that supports the wafer 1 during processing of the wafer 1, and a temporary adhesive material layer 2 interposed between the wafer 1 and the support 3, wherein the temporary adhesive material layer 2 has a two-layered structure that includes a thermoplastic resin layer (A) (first temporary adhesive layer) and a thermosetting siloxane polymer layer (B) (second temporary adhesive layer), and the first temporary adhesive layer is peelably adhered to the front side of the wafer 1, and the second temporary adhesive layer is peelably adhered to the first temporary adhesive layer.

In this way, the temporary adhesive material for wafer processing of the present invention is composed of the laminate of the above (A) and (B).

The temporary adhesive material for wafer processing of the present invention can provide a wafer processing body that has, irrespective of the surface treatment condition of the surface of the circuit-bearing substrate, stable adhesion between the circuit-bearing substrate and the support as well as peelability of the support, allows for easy cleaning of residues of the temporary adhesive material layer after peeling of the support, can form a temporary adhesive material layer with uniform film thickness even on a substrate with a large step height, exhibits high process compatibility with TSV formation and wafer backside wiring processes, and furthermore exhibits excellent resistance to wafer thermal processes such as CVD, thereby enhancing the productivity of thin wafers, and also provide a method for producing a thin wafer using the temporary adhesive material for wafer processing.

[Temporary Adhesive Material Layer]

-First Temporary Adhesion Layer/Thermoplastic Resin Layer (A) (Thermoplastic Polymer Layer)-

The first temporary adhesive layer is composed of a thermoplastic resin layer (A). In view of the applicability to silicon wafers with steps, a thermoplastic resin with excellent spin-coating properties is preferably used as the material for forming the first temporary adhesive layer. In particular, the thermoplastic resin is preferably a thermoplastic resin with a glass transition temperature of approximately -80 to 120°C, and further preferably a non-silicone thermoplastic resin. Examples thereof include an olefin-based thermoplastic elastomer, a polybutadiene-based thermoplastic elastomer, a styrene-based thermoplastic elastomer, a styrene-butadiene-based thermoplastic elastomer, and a styrene-polyolefin-based thermoplastic elastomer. In particular a hydrogenated polystyrene elastomer that is excellent in heat resistance, is suitable. Specific examples include Tuftec (Asahi Kasei Chemicals Corporation), Espolex SB series (SUMITOMO CHEMICAL COMPANY, LIMITED), RABALON (Mitsubishi Chemical Corporation), SEPTON (Kuraray Co., Ltd.), and DYNARON (JSR Corporation). Further examples include cyclo-olefin polymers represented by ZEONEX (ZEON CORPORATION), and cyclic olefin copolymers, represented by TOPAS (Polyplastics Co., Ltd.).

When the first temporary adhesive layer is composed of a non-silicone-based thermoplastic resin, characteristics such as the reduction of wafer warpage during bonding, shortening bonding process time, good peelability between the substrate and the support, and cleaning removability are good.

As mentioned above, it is preferable that the thermoplastic resin layer (A) is a thermoplastic elastomer.

With such a configuration, after production of a thin wafer, this wafer can be easily peeled from the support, thereby enabling easy handling of fragile thin wafers.

This thermoplastic resin layer is formed on a semiconductor substrate such as a silicon wafer by dissolving the thermoplastic resin in a solvent and applying it by methods such as spin coating or spray coating. Examples of the solvent include hydrocarbon-based solvents, preferably nonane, p-menthane, pinene, and isooctane. Among them, in view of the coating properties, nonane, p-menthane, and isooctane are more preferred. The amount of the solvent used for dilution can be adjusted appropriately depending on the workability and the target film thickness, but it is preferable that the solvent is mixed in the amount of 100 to 2,000 parts by mass based on 100 parts by mass of the thermoplastic resin. The thickness of the film to be formed is not limited, but it is desirable to form a resin film according to the steps on the substrate, and preferably, a film having a thickness of 0.5 μm to 50 μm, more preferably 0.5 to 10 μm, is formed. This thermoplastic resin can contain an antioxidant to improve heat resistance, and a surfactant to improve coating properties. Examples of the antioxidant that can be used include known antioxidants, and di-t-butylphenol and the like are suitably used. Examples of the surfactant that can be used include fluorosilicone-based surfactants, and X-70-1102 (manufactured by Shin-Etsu Chemical Co., Ltd.) and the like are suitably used.

-Second Temporary Adhesive Layer/Thermosetting Siloxane Polymer Layer (B) (Thermosetting Silicone Polymer Layer)-

The thermosetting siloxane polymer layer (B), which is a component of the wafer processing body and the temporary adhesive material for wafer processing of the present invention, is not particularly limited as long as it contains a thermosetting siloxane polymer. For example, it is preferably a cured product layer of a thermosetting siloxane composition containing the following components (B-1) to (B-4) and optionally the component (B-5) described later:

(B-1) organopolysiloxane having two or more alkenyl groups in one molecule in an amount of 100 parts by mass,
(B-2) organohydrogenpolysiloxane containing two or more silicon atom-bonded hydrogen atoms (Si-H groups) in one molecule in an amount such that a molar ratio of the Si-H group in component (B-2) to the alkenyl group in the component (B-1) is 0.3 to 10,
(B-3) non-functional organopolysiloxane in an amount of 0.1 to 200 parts by mass,
(B-4) a hydrosilylation reaction catalyst in an amount of 0.1 to 5,000 ppm in terms of metal atom amount based on a total mass of the components (B-1), (B-2), and (B-3).

It is preferable that the thermosetting siloxane composition further contains a reaction control agent (a hydrosilylation reaction control agent) as component (B-5) and an amount of the component (B-5) added is 0.0001 to 50 parts by mass based on the total mass of the components (B-1), (B-2), and (B-3).

Hereinafter, each component that constitutes the above thermosetting siloxane composition is described.

[Component (B-1)]

The component (B-1) is organopolysiloxane having two or more alkenyl groups in one molecule. Examples of the component (B-1) include linear or branched diorganopolysiloxane containing two or more alkenyl groups in one molecule, and three-dimensional networked organopolysiloxane containing two or more alkenyl groups in one molecule and having siloxane units (Q units) represented by $SiO_{4/2}$ units. Among these, diorganopolysiloxane or three-dimensional networked organopolysiloxane having an alkenyl group content rate of 0.6 to 9 mol% is preferred. It should be noted that in the present invention, the alkenyl group content rate refers to the proportion of siloxane units containing an alkenyl group to all siloxane units.

Examples of such organopolysiloxane include those represented by the following formula (B-1-1), (B-1-2), or (B-1-3). These may be used alone or in combination of two or more.

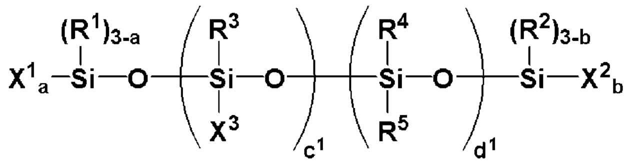

(B-1-1)

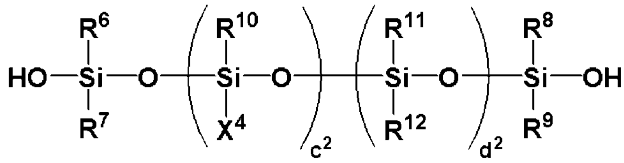

(B-1-2)

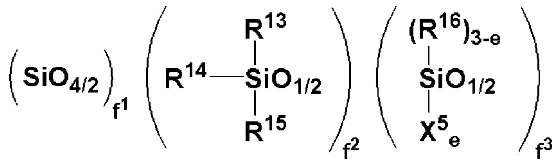

(B-1-3)

In formulae (B-1-1) to (B-1-3), $R^1$ to $R^{16}$ are each independently a monovalent hydrocarbon group other than an aliphatic unsaturated hydrocarbon group. $X^1$ to $X^5$ are each independently a monovalent organic group containing an alkenyl group.

In formula (B-1-1), "a" and "b" are each independently an integer of 0 to 3. In the formulae (B-1-1) and (B-1-2), "$c^1$", "$c^2$", "$d^1$", and "$d^2$" are integers that satisfy $0 \leq c^1 \leq 10$, $2 \leq c^2 \leq 10$, $0 \leq d^1 \leq 100$, and $0 \leq d^2 \leq 100$. In addition, $a + b + c^1 \geq 2$. It is preferable that "a", "b", "$c^1$", "$c^2$", "$d^1$", and "$d^2$" are a combination of numbers such that the alkenyl group content rate is 0.6 to 9 mol%.

In formula (B-1-3), "e" is an integer of 1 to 3. "$f^1$", "$f^2$", and "$f^3$" are numbers such that $(f^2 + f^3)/f^1$ becomes 0.3 to 3.0, and $f^3/(f^1 + f^2 + f^3)$ becomes 0.01 to 0.6.

As the monovalent hydrocarbon group other than an aliphatic unsaturated hydrocarbon group, those having 1 to 10 carbon atoms are preferred. Examples thereof include an alkyl group such as a methyl group, an ethyl group, an n-propyl group, an isopropyl group, an n-butyl group, a tert-butyl group, an n-pentyl group, and an n-hexyl group; a cycloalkyl group such as a cyclopentyl group and a cyclohexyl group; and an aryl group such as a phenyl group and a tolyl group. Among these, an alkyl group such as a methyl group, or a phenyl group is preferred.

As the monovalent organic group containing an alkenyl group, those having 2 to 10 carbon atoms are preferred. Examples thereof include an alkenyl group such as a vinyl group, an allyl group, a hexenyl group, and an octenyl group; a (meth)acryloylalkyl group such as an acryloylpropyl group, an acryloylmethyl group, and a methacryloylpropyl group; a (meth)acryloxyalkyl group such as an acryloxypropyl group, an acryloxymethyl group, a methacryloxypropyl group, and a methacryloxymethyl group; and an alkenyl group-containing monovalent hydrocarbon group such as a cyclohexenylethyl group and a vinyloxypropyl group. Among these, from an industrial view, a vinyl group is preferred.

In formula (B-1-1), "a" and "b" are each independently an integer of 0 to 3. However, it is preferable that "a" is 1 to 3 because the end of the molecular chain is capped with an alkenyl group, which allows the reaction to complete in a short time due to the highly reactive alkenyl group at the molecular chain end. Additionally, in terms of cost, it is industrially preferable that "a" is 1. The physical form of the alkenyl group-containing diorganopolysiloxane represented by formula (B-1-1) or (B-1-2) is preferably oil-like or raw rubber-like.

The organopolysiloxane represented by formula (B-1-3) contains $SiO_{4/2}$ units and has a three-dimensional network structure. In formula (B-1-3), "e" is each independently an integer of 1 to 3, but in terms of cost, it is industrially preferable that "e" is 1. Additionally, it is preferable that the product of the average value of "e" and $f^3/(f^1 + f^2 + f^3)$ is 0.02 to 1.5, more preferably 0.03 to 1.0. The organopolysiloxane represented by the formula (B-1-3) may also be used in the form of a solution prepared by dissolving it in an organic solvent.

The number average molecular weight (Mn) of the organopolysiloxane of component (B-1) is preferably 100 to 1,000,000, more preferably 500 to 100,000, and further preferably 1,000 to 100,00. When Mn is within the range described above, it is preferable in terms of workability associated with viscosity of the composition and processability associated with the storage modulus after curing. It should be noted that in the present invention, Mn is a measurement value in terms of polystyrene obtained by gel permeation chromatography using toluene as solvent.

The component (B-1) may be used alone or in combination of two or more. In particular, it is preferable to use a combination of the organopolysiloxane represented by formula (B-1-1) and the organopolysiloxane represented by formula (B-1-3). At this time, the amount of organopolysiloxane used represented by formula (B-1-3) is preferably 1 to

1,000 parts by mass, more preferably 10 to 500 parts by mass, based on 100 parts by mass of the organopolysiloxane represented by formula (B-1-1).

[Component (B-2)]

The component (B-2) is a crosslinking agent, which is an organohydrogenpolysiloxane having at least two, preferably three or more, silicon atom-bonded hydrogen atoms (SiH groups) in one molecule. The organohydrogenpolysiloxane may be linear, branched, or cyclic. The organohydrogenpolysiloxane may be used alone or in combination of two or more.
The viscosity at 25°C of organohydrogenpolysiloxane of the component (B-2) is preferably 1 to 5,000 mPa·s and more preferably 5 to 500 mPa·s. It should be noted that in the present invention, the viscosity is a measurement value obtained at 25°C with a rotational viscometer.
The Mn of organohydrogenpolysiloxane of the component (B-2) is preferably 100 to 100,000, and more preferably 500 to 10,000. When Mn is within the range described above, it is preferable in terms of workability associated with viscosity of the composition and processability associated with the storage modulus after curing.
It is preferable that the component (B-2) is mixed such that the molar ratio (SiH group/alkenyl group) of the total SiH groups in the component (B-2) to the total alkenyl groups in the component (B-1) is in a range of 0.3 to 10, more preferably in a range of 0.5 to 5.0, and further preferably in a range of 0.7 to 3.0. When the molar ratio is 0.3 or more, the cross-linking density can be sufficiently high and the temporary adhesive material layer can be more reliably cured. When the molar ratio is 10 or less, the crosslinking density can be appropriately controlled, sufficient adhesive strength and tackiness can be obtained, and the pot life of the treatment liquid can be extended.

[Component (B-3)]

The component (B-3) is non-functional organopolysiloxane. The "non-functional" as used herein means that the organopolysiloxane has, in the molecule, no reactive groups such as a hydrogen atom, a halogen atom, a hydroxy group, or an alkoxy group directly bound to a silicon atom, and no reactive groups such as an alkenyl group or an epoxy group bonded directly or through any group to a silicon atom.
Examples of such a non-functional organopolysiloxane include organopolysiloxanes having an unsubstituted or substituted monovalent hydrocarbon group having 1 to 12 carbon atoms, preferably 1 to 10 carbon atoms, other than an aliphatic unsaturated hydrocarbon group. Examples of such a monovalent hydrocarbon group include an alkyl group such as a methyl group, an ethyl group, a propyl group, a butyl group, a pentyl group, a hexyl group, and a heptyl group; a cycloalkyl group such as a cyclohexyl group; an aryl group such as a phenyl group, a tolyl group, a xylyl group, and a naphthyl group; and an aralkyl group such as a benzyl group and a phenethyl group. In addition, some or all of hydrogen atoms of these groups may be replaced by a halogen atom such as a chlorine atom, a fluorine atom, or a bromine atom. Examples of such a group include a halogenated alkyl group such as a chloromethyl group, a 3-chloropropyl group, and a 3,3,3-trifluoropropyl group. The monovalent hydrocarbon group is preferably an alkyl group or an aryl group, and more preferably a methyl group or a phenyl group.
The molecular structure of the non-functional organopolysiloxane of the component (B-3) is not particularly limited and can be linear, branched, or cyclic, but the non-functional organopolysiloxane is preferably a linear or branched organopolysiloxane, and preferably a linear diorganopolysiloxane in which the main chain basically consists of repeating diorganosiloxane units and both ends of its molecular chain are capped with triorganosiloxy groups.
The viscosity of the non-functional organopolysiloxane of the component (B-3) at 25°C in its 30% by mass toluene solution is preferably 100 to 500,000 mPa·s, more preferably 1,000 to 400,000 mPa·s, and further preferably 10,000 to 300,000 mPa·s, from the viewpoints of workability of the composition, applicability to substrates, mechanical properties of the cured product, peelability of the support, and the like. With the range described above, the non-functional organopolysiloxane has an appropriate molecular weight, thus it does not volatilize to the point that loses its effectiveness during the heat curing of the silicone resin composition, nor does it cause wafer cracking during wafer thermal processes like CVD while it exhibits good workability and coatability, making it preferable.
Examples of the non-functional organopolysiloxane include a dimethylsiloxane polymer capped with trimethylsiloxy groups at both molecular chain ends, phenylmethylpolysiloxane capped with trimethylsiloxy groups at both molecular chain ends, a 3,3,3-trifluoropropylmethylsiloxane polymer capped with trimethylsiloxy groups at both molecular chain ends, a dimethylsiloxane-methylphenylsiloxane copolymer capped with trimethylsiloxy groups at both molecular chain ends, a dimethylsiloxane-3,3,3-trifluoropropylmethyl copolymer capped with trimethylsiloxy groups at both molecular chain ends, a methylphenylsiloxane-3,3,3-trifluoropropylmethyl copolymer capped with trimethylsiloxy groups at both molecular chain ends, a dimethylsiloxane-3,3,3-trifluoropropylmethylsiloxane-methylphenylsiloxane copolymer capped with trimethylsiloxy groups at both molecular chain ends, dimethylpolysiloxane capped with dimethylphenylsiloxy

groups at both molecular chain ends, methylphenylpolysiloxane capped with dimethylphenylsiloxy groups at both molecular chain ends, and a dimethylsiloxane-methylphenylsiloxane copolymer capped with dimethylphenylsiloxy groups at both molecular chain ends.

The non-functional organopolysiloxane of component (B-3) may be used alone or in combination of two or more. In addition, it is preferable that the physical form thereof is either oil-like or raw rubber-like.

The component (B-3) is preferably mixed in an amount of 0.1 to 200 parts by mass, more preferably 1 to 100 parts by mass, based on 100 parts by mass of the component (B-1). When the mixing ratio is 0.1 parts by mass or more, it is preferable because it allows easy peeling, especially in the peeling process of the support from the substrate. Furthermore, when the mixing ratio is 200 parts by mass or less, it is preferable because wafer processing durability can be achieved without peeling off of the wafer during wafer processing such as backside grinding or subsequent heat treatment.

[Component (B-4)]

The component (B-4) is a hydrosilylation reaction catalyst, preferably a platinum group metal-based hydrosilylation reaction catalyst. The component (B-4) is a catalyst that promotes the addition reaction between the alkenyl group in the component (B-1) and the hydrosilyl group in the component (B-2). This hydrosilylation reaction catalyst is generally a noble metal compound and costly, thus platinum or platinum compounds, which are readily available, are often used.

Examples of the platinum compound include chloroplatinic acid or complexes of chloroplatinic acid with olefins such as ethylene, complexes with alcohols or vinyl siloxanes, and metallic platinum supported on carriers like silica, alumina, or carbon. As the platinum group metal catalysts other than platinum compounds, rhodium, ruthenium, iridium, and palladium-based compounds are known, and examples thereof include, $RhCl(PPh_3)_3$, $RhCl(CO)(PPh_3)_2$, $Ru_3(CO)_{12}$, $IrCl(CO)(PPh_3)_2$, and $Pd(PPh_3)_4$, wherein Ph represents a phenyl group.

When using these catalysts, if they are solid catalysts, it is possible to use them in a solid form. However, to obtain a more uniform cured product, it is preferable to dissolve chloroplatinic acid or complexes in an appropriate solvent and use it by making it compatible with the component (B-1).

The amount of the component (B-4) added is an effective amount, and it is usually 0.1 to 5,000 ppm, preferably 0.5 to 2,000 ppm, and more preferably 1 to 500 ppm in terms of metal atom amount based on the total mass of components (B-1), (B-2), and (B-3). When the amount is 0.1 ppm or more, there is no reduction in curability of the composition, crosslinking density, or retention force. When the amount is 5,000 ppm or less, it is possible to suppress side reactions such as dehydrogenation during curing, and extend the pot life of the treatment solution.

[Component (B-5)]

The thermosetting silicone resin composition may further contain a reaction control agent (hydrosilylation reaction control agent) as component (B-5). The reaction control agent is optionally added as needed to prevent the composition from thickening or gelling when preparing or applying the composition to a substrate.

Example of the reaction control agent include 3-methyl-1-butyne-3-ol, 3-methyl-1-pentyne-3-ol, 3,5-dimethyl-1-hexyne-3-ol, 1-ethynylcyclohexanol, 3-methyl-3-trimethylsiloxy-1-butyne, 3-methyl-3-trimethylsiloxy-1-pentyne, 3,5-dimethyl-3-trimethylsiloxy-1-hexyne, 1-ethynyl-1-trimethylsiloxycyclohexane, bis(2,2-dimethyl-3-butinyloxy)dimethylsilane, 1,3,5,7-tetramethyl-1,3,5,7-tetravinylcyclotetrasiloxane, and 1,1,3,3-tetramethyl-1,3-divinyldisiloxane. Among these, 1-ethynylcyclohexanol and 3-methyl-1-butyne-3-ol are preferred.

When the thermosetting silicone resin composition contains the component (B-5), the content thereof should be appropriately adjusted, since its controlling capability varies depending on its chemical structure. However, in view of curability, storage stability, the impact on physical properties after curing, and the like, the content is preferably 0.0001 to 50 parts by mass, more preferably 0.001 to 10 parts by mass based on the total mass of the components (B-1), (B-2), and (B-3). When the content of the component (B-5) is in the range, the pot life of the composition is extended, long-term storage stability is obtained, and the curability and workability are good.

[Other components]

The thermosetting siloxane composition may additionally contain the following components as needed.

(Organopolysiloxane)

The thermosetting siloxane composition may contain organopolysiloxane that contains an $R^A{}_3SiO_{0.5}$ unit, wherein $R^A$ is each independently an unsubstituted or substituted monovalent hydrocarbon group having 1 to 10 carbon atoms, and an $SiO_2$ unit, and has a molar ratio of $R^A{}_3SiO_{0.5}$ unit to $SiO_2$ unit ($R^A{}_3SiO_{0.5}/SiO_2$) of 0.3 to 1.8. The amount

thereof is preferably 0 to 500 parts by mass based on 100 parts by mass of the component (B-1).

(Solvent)

The thermosetting siloxane composition can be used by dissolving it in a compatible solvent to improve workability and mixability associated with the reduction in viscosity of the composition, to adjust the film thickness of the polymer layer (B), and the like. The solvent used is not particularly limited as long as it dissolves the composition, but hydrocarbon-based solvents such as pentane, hexane, cyclohexane, isooctane, nonane, decane, p-menthane, pinene, isododecane, and limonene are preferably used.

Examples of the method of dissolving the composition include a method of preparing the thermosetting siloxane composition and then finally adding a solvent to adjust to the desired viscosity, and a method of pre-diluting the high-viscosity (B-1) and/or (B-2) with a solvent to improve workability and mixability, and mixing the remaining components to prepare the thermosetting siloxane polymer layer (B) composition. In addition, the mixing method when dissolving may be appropriately selected from the methods using a shaking mixer, a magnetic stirrer, various mixers, or the like based on the viscosity of the composition and workability.

The amount of the solvent to be mixed can be appropriately set based on the viscosity of the composition and workability, the adjustment of the film thickness of the thermosetting siloxane polymer layer (B), or the like. For example, the amount is 5 to 900 parts by mass, preferably 10 to 400 parts by mass, based on 100 parts by mass of the thermosetting siloxane polymer layer (B) composition.

[Thermosetting Siloxane Polymer Layer (B) Forming Method and the Like]

The thermosetting siloxane polymer layer (B) can be formed and used on a support by methods such as spin coating or roll coating using a thermosetting siloxane composition or its solution. Among these, when forming the thermosetting siloxane polymer layer (B) on a support or on a circuit-bearing substrate where the thermoplastic resin layer (A) has been formed in advance by methods such as spin coating, it is preferable to coat the polymer layer (B) as a solution.

In addition, known antioxidants can be added to the solution to improve heat resistance.

The thermosetting siloxane polymer layer (B) is preferably formed and used with a film thickness of 0.1 to 100 μm, more preferably 1.0 to 80 μm. When the film thickness is 0.1 μm or more, it can be applied over the entire surface without leaving any uncoated areas during coating onto the support or substrate. When the film thickness is 80 μm or less, it can sufficiently withstand the grinding process when forming a thin wafer. To the thermosetting siloxane polymer layer (B), fillers such as silica may be added as needed to further enhance heat resistance.

The thermosetting siloxane polymer layer (B) has, after curing, a 180° peel strength of typically 2 gf (0.020 N) or more and 500 gf (4.9 N) or less, preferably 3 gf (0.029 N) or more and 100 gf (0.98 N) or less, and more preferably 5 gf (0.049 N) or more and 30 gf (0.29 N) or less, when tested with a 25 mm-wide test piece (for example, a polyimide test piece) against the thermoplastic resin layer (A) at 25°C. When the peel strength is 2 gf or more, there is no risk of wafer misalignment during wafer grinding, and when it is 500 gf or less, wafer peeling becomes easy, making it preferable.

In addition, the thermosetting siloxane polymer layer (B) has, after curing, a storage modulus of typically 1,000 Pa or more and 1,000 MPa or less, preferably 10,000 Pa or more and 500 MPa or less, and more preferably 100 kPa to 300 MPa, at 25°C. When the storage modulus is 1,000 Pa or more, the strength of the film formed is sufficient and there is no risk of wafer misalignment and the resulting wafer breakage during wafer grinding. When the storage modulus is 1,000 MPa or less, it can alleviate the deformation stress during wafer thermal processes such as CVD, thereby eliminating the risk of wafer breakage.

[Method for Producing Thin Wafer]

The method for producing a thin wafer of the present invention is characterized by using a composite temporary adhesive material layer that includes two layers of a thermoplastic resin layer (A) and a thermosetting siloxane polymer layer (B) as the adhesive layer between a wafer having a semiconductor circuit or the like and a support. Two embodiments thereof are shown here. In both embodiments, the thickness of the thin wafer obtained by the production method of the present invention is typically 5 to 300 μm, and more typically 10 to 100 μm. The steps (b) to (e) in each embodiment and the subsequent steps are the same, and step (a) preceding the step (b) is shown as step (a1) in the first embodiment and as step (a2) in the second embodiment.

The method for producing a thin wafer of the present invention includes the following steps (a1) to (e) as the first embodiment, and steps (f) to (i) as needed.

[Step (a1)]

The step (a1) is a step of, when bonding a support and a circuit-forming surface of a wafer having the circuit-forming surface on a front side and a non-circuit-forming surface on a backside via the temporary adhesive material for wafer processing of the present invention (i.e., a temporary adhesive material layer having a thermoplastic resin layer (A) and a thermosetting siloxane polymer layer (B)), forming the thermosetting siloxane polymer layer (B) on the support, and then bonding the obtained support and the wafer in which the thermoplastic resin layer (A) is formed on the circuit-forming surface under vacuum. This step is a step of, when bonding a support and a circuit-forming surface of a wafer having the circuit-forming surface on a front side and a non-circuit-forming surface on a backside via a temporary adhesive material layer having a thermoplastic resin layer (A) and a thermosetting siloxane polymer layer (B) used for the temporary adhesive material for wafer processing of the present invention, forming the thermosetting siloxane polymer layer (B) on the support, and then bonding this polymer layer (B)-formed support and the circuit-bearing wafer in which the thermoplastic resin layer (A) is formed under vacuum.

The wafer having a circuit-forming surface and a non-circuit-forming surface is a wafer having circuit-forming surface on one side and the non-circuit-forming surface on the other side. The wafer to which the present invention can be applied is typically a semiconductor wafer. Examples of the semiconductor wafer include not only a silicon wafer but also a germanium wafer, a gallium-arsenide wafer, a gallium-phosphide wafer, and a gallium-arsenide-aluminum wafer. The thickness of the wafer is not particularly limited, but is typically 600 to 800 μm, more typically 625 to 775 μm.

On the circuit-forming surface, any surface treatments and coatings such as a passivation film of $SiO_2$, $Si_3N_4$, SiON, or SiOC, and a buffer coat film, e.g. a polyimide (PI) film or polybenzoxazole (PBO) film, may be applied. In this way, the present invention is particularly suitable for a wafer in which the circuit-forming surface is surface-treated with a material different from a base material of the wafer.

Examples of the support include, but are not limited to, a substrate such as a silicon wafer, a glass plate, and a quartz wafer. It is not necessary to irradiate the temporary adhesive material layer with radiation energy through the support in the present invention, and the support may be non-light-transmissive.

The first temporary adhesive layer including a thermoplastic resin layer (A) and the second temporary adhesive layer including a thermosetting siloxane polymer layer (B) can each be formed as a film on a wafer or support. Alternatively, compositions or its solutions providing each layer can be applied to the wafer or support by methods such as spin coating or roll coating. When using as a solution, the solution is spin-coated, and then pre-baked in accordance with the volatilization conditions of the solvent at a temperature of 20 to 200°C, preferably 30 to 150°C, and then subjected to further use.

The wafer and the support, where the first temporary adhesive layer including the thermoplastic resin layer (A) and the second temporary adhesive layer including the thermosetting siloxane polymer layer (B) have been formed are formed as a substrate in which they are bonded via the layers (A) and (B). At this time, the substrate is uniformly pressed, preferably in a temperature range of 0 to 200°C, more preferably 20 to 150°C, under reduced pressure (under vacuum) at the temperature to form a wafer processing body (laminated substrate) in which the wafer is bonded with the support.

The pressure when bonding the wafer and support on which a temporary adhesive material layer is formed by pressure depends on the viscosity of the temporary adhesive material layer, but is preferably 0.01 to 10 MPa, more preferably 0.1 to 1.0 MPa. When the pressure is 0.01 MPa or more, the space between the circuit-forming surface or the wafer and the support can be filled with the temporary adhesive material layer, and when the pressure is 10 MPa or less, there is no risk of causing wafer cracking or deterioration of the flatness of the wafer and the temporary adhesive material layer, ensuring excellent subsequent wafer processing.

Examples of the wafer bonding apparatus include commercially available wafer bonding apparatuses such as EVG520IS and 850TB manufactured by EV Group and XBS300 manufactured by SUSS MicroTec SE.

[Step (b)]

Step (b) is a step of thermally curing the composite temporary adhesive material layer. After forming the wafer processing body, the composite temporary adhesive material layer is cured by heating preferably at 50 to 300°C, more preferably at 100 to 200°C, for preferably 1 minute to 4 hours, more preferably 5 minutes to 2 hours.

[Step (c)]

The step (c) is a grinding or polishing the non-circuit-forming surface of the wafer bonded with the support, that is, grinding the backside of the wafer processing body obtained by bonding through the step (b) to reduce the thickness of the wafer. There are no specific limitations on the method of grinding the wafer backside, and a known grinding method is employed. It is preferable to perform grinding while cooling the wafer and the grinding wheel (such as diamond) with water. Examples of the apparatus for grinding the wafer backside include DAG-810 (product name) manufactured by DISCO Corporation. The wafer backside may be polished by CMP.

[Step (d)]

The step (d) is a step of processing the non-circuit-forming surface of the wafer processing body in which the non-circuit-forming surface has been ground, i.e., the wafer processing body that has been thinned by the backside grinding. This step includes various wafer-level processes. Examples thereof include electrode formation, metal wiring formation, and protective-film formation. More specific examples include conventional known processes such as metal sputtering for forming electrodes, wet etching for etching a metal sputtering layer, application of resist for masking metal wiring formation, exposure and development for pattern formation, resist stripping, dry etching, formation of metal plating, silicon etching for TSV formation, and oxidation film formation on a silicon surface.

[Step (e)]

The step (e) is a step of peeling the processed wafer in the step (d) from the support, that is, a step of, after subjecting the thinned wafer to various processes, peeling the wafer from the support before dicing. Examples of this peeling step include a method of fixing one of the wafer or the support of the wafer processing body horizontally, optionally heating it to about 100°C, and peeling off the other side at a certain angle from the horizontal direction, a method of immersing the wafer processing body in a solvent in advance to swell the temporary adhesive material layer and then peeling it in the same manner as above, a method of applying a protective film to the ground surface of the ground wafer and peeling the wafer and the protective film, and a method of fixing one of the wafer or the support of the wafer processing body horizontally, heating it to about 100°C, and sliding the other side using the plasticity of the thermoplastic resin layer (A).

Any of these peeling methods can be applied to the present invention, but the peeling method is not limited to the above methods.

Furthermore, it is preferable that the step (e) of peeling the wafer, which has been processed, from the support is particularly includes the following steps because it facilitates the peeling of the support from the wafer which has been processed, reduces damage to the wafer during separation, and allows for an easy transition to the dicing step after peeling.

(f) a step of attaching a dicing tape to the wafer surface of the processed wafer
(g) a step of vacuum-adsorbing the dicing tape surface to the adsorption surface
(h) a step of peeling the support from the processed wafer by peeling off at a temperature of the adsorption surface ranging from 10°C to 100°C

Additionally, it is preferable to perform, after the step (e) of peeling the processed wafer from the support, (i) a step of removing the temporary adhesive material layer remaining on the circuit-forming surface of the peeled wafer. The thermoplastic resin layer (A) might partially remain on the circuit-forming surface of the wafer that has been peeled from the support in the step (e). The thermoplastic resin layer (A) can be removed, for example, by cleaning the wafer.

In this step (i), any cleaning solution that can dissolve the thermoplastic resin layer, which is the layer (A) of the temporary adhesive material layer, can be used, and specific examples thereof include pentane, hexane, cyclohexane, decane, isononane, p-menthane, pinene, isododecane, and limonene. These solvents may be used alone or in combination of two or more. When it is difficult to remove, bases or acids may be added to the above solvent. Examples of the bases include amines such as ethanolamine, diethanolamine, triethanolamine, triethylamine, and ammonia and ammonium salts such as tetramethylammonium hydroxide. Examples of the acids include organic acids such as acetic acid, oxalic acid, benzenesulfonic acid, and dodecylbenzenesulfonic acid. The addition amount thereof is 0.01 to 10% by mass, preferably 0.1 to 5% by mass, in terms of concentration in the cleaning solution. In addition, an existing surfactant may be added to improve the removability of the residues. Furthermore, the SPIS-TA-CLEANER series (manufactured by Shin-Etsu Chemical Co., Ltd.) available as a wafer cleaner can also be suitably used. Examples of the cleaning method include a cleaning method using the above liquid with a paddle, a cleaning method by applying a spray, and a method by immersing in a cleaning liquid tank. The temperature should be between 10 to 80°C, preferably 15 to 65°C, and if necessary, the layer (A) can be dissolved with these dissolving solutions, then finally rinsed with water or alcohol, followed by drying treatment to obtain a thin wafer.

The second embodiment of the method for producing a thin wafer of the present invention includes the following step (a2) that is an embodiment of step (a). Steps following the step (a2), namely steps (b) to (e), preferably steps (b) to (h) or steps (b) to (i), are the same as in the first embodiment described above.

[Step (a2)]

The step (a2) is a step of, when bonding a support and a circuit-forming surface of a wafer having the circuit-forming surface on a front side and a non-circuit-forming surface on a backside via the temporary adhesive material for wafer processing described above, first forming the thermoplastic resin layer (A) on the circuit-forming surface of the wafer, subsequently forming the thermosetting siloxane polymer layer (B) on the thermoplastic resin layer (A), and then bonding the support and the obtained wafer under vacuum.

The method for forming the first and second temporary adhesive layers can be performed in the same manner as the first embodiment, where each temporary adhesive layer can be formed as a film or with a corresponding composition or its solution applied by methods such as spin coating or roll coating on a wafer or support. When using a solution, the solution is spin-coated, and then pre-baked in accordance with the volatilization conditions of the solvent at a temperature of 20 to 200°C, preferably 30 to 150°C, and then subjected to further use.

The thickness of the thin wafer obtained by the production method of the present invention is typically 5 to 300 μm, and more typically 10 to 100 μm.

EXAMPLE

Hereinafter, the present invention will be described in detail with reference to Resin Solution Preparation Examples (Preparation Examples, Comparative Preparation Examples), Examples, and Comparative Examples, but the present invention is not limited to these. It should be noted that the viscosity is a measurement value obtained at 25°C with a rotational viscometer, and the number average molecular weight is the result measured by GPC using toluene as the solvent.

[Resin Solution Preparation Example 1]

24 g of hydrogenated polystyrene-based thermoplastic resin SEPTON 4033 (manufactured by Kuraray Co., Ltd., SEEPS, styrene content 30%), whose general structural formula is as shown below, was dissolved in 176 g of isononane to obtain a 12% by mass solution of SEPTON 4033 in isononane. The obtained solution was filtered through a 0.2 μm membrane filter to obtain an isononane solution of thermoplastic resin (A-1).

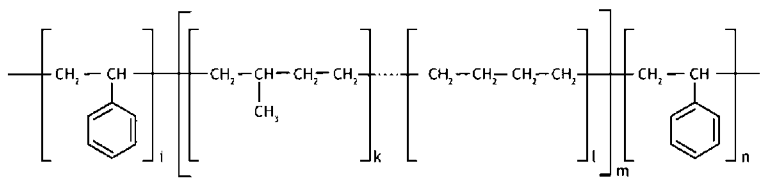

[Resin Solution Preparation Example 2]

12 g of hydrogenated polystyrene-based thermoplastic resin SEPTON 4044 (manufactured by Kuraray Co., Ltd., SEEPS, styrene content 32%), whose general structural formula is as shown below, was dissolved in 188 g of isononane to obtain a 6% by mass solution of SEPTON 4044 in isononane. The obtained solution was filtered through a 0.2 μm membrane filter to obtain an isononane solution of thermoplastic resin (A-2).

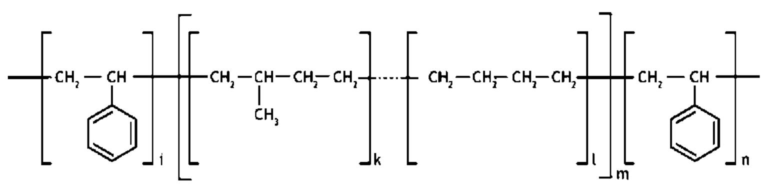

[Resin Solution Preparation Example 3]

To a solution consisting of 100 parts by mass of dimethylpolysiloxane composed of 97.5 mol% of $(CH_3)_2SiO_{2/2}$ units (D units) and 2.5 mol% of $(CH_2=CH)(CH_3)SiO_{2/2}$ units ($D^{Vi}$ units) and having Mn of 30,000 and 200 parts by mass of toluene, a solution consisting of 50 parts by mass of vinylmethylpolysiloxane of resin structure composed of 50 mol% of $SiO_{4/2}$ units (Q units), 48 mol% of $(CH_3)_3SiO_{1/2}$ units (M units) and 2 mol% of $(CH_2=CH)(CH_3)_2SiO_{1/2}$ units ($M^{Vi}$ units) and having Mn of 7,000 and 100 parts by mass of toluene, a solution consisting of 21 parts by mass of organohydrogenpolysiloxane composed of 83.9 mol% of $(CH_3)_2SiO_{2/2}$ units (D units) and 16.1 mol% of $(CH_3)HSiO_{2/2}$ units ($D^H$ units) and having Mn of 2,400, 50 parts by mass of dimethylpolysiloxane capped with trimethylsiloxy groups at both molecular chain ends and having a viscosity (25°C) of 30,000 mPa·s in a 30% by mass toluene solution and 120 parts by mass of toluene,

and 0.6 parts by mass of 1-ethynylcyclohexanol were added and mixed. Furthermore, 0.4 parts by mass of a hydrosilylation reaction catalyst CAT-PL-5 (manufactured by Shin-Etsu Chemical Co., Ltd., platinum concentration of 1.0% by mass) was added, and the mixture was filtered through a 0.2 μm membrane filter to prepare a thermosetting silicone resin solution (B-1). The viscosity of the resin solution (B-1) at 25°C was 2,300 mPa·s.

The value of (Si-H/Si-Vi) of the total SiH groups in the component (B) to the total alkenyl groups in the component (A) in Resin Solution Preparation Example 3 is calculated using the following formulae.

(1) Si-Vi amount (moles) from PDMS

(PDMS addition amount/PDMS molecular weight) × <PDMS molecular weight/{[(D unit molecular weight) × (D unit mol%/100) ] + [($D^{Vi}$ unit molecular weight) × ($D^{Vi}$ unit mol%/100) ]}> × ($D^{Vi}$ unit mol%/100)

(2) Si-Vi amount (mol) from PVMS of resin structure having Vi group

(PVMS addition amount/PVMS molecular weight) × <PVMS molecular weight/{[(Q unit molecular weight) × (Q unit mol%/100)] + [(M unit molecular weight) × (M unit mol%/100)] + [($M^{Vi}$ unit molecular weight) × ($M^{Vi}$ unit mol %/100) ]}> × ($M^{Vi}$ unit mol%/100)

(3) Si-H amount from POHS (mol)

(POHS addition amount/POHS molecular weight) × <PVMS molecular weight/{[(D unit molecular weight) × (D unit mol%/100)] + [($D^H$ unit molecular weight) × ($D^H$ unit mol%/100) ]}> × ($D^H$ unit mol%/100)

In the formulae, PDMS: dimethylpolysiloxane, PVMS: vinylmethylpolysiloxane of resin structure, and POHS: organohydrogenpolysiloxane.

The Si-H/Si-Vi (molar ratio) in Resin Solution Preparation Example 3 obtained by the above formulae (1) to (3) is 1.0.

[Resin Solution Preparation Example 4]

To a solution consisting of 70 parts by mass of dimethylpolysiloxane composed of 97.5 mol% of $(CH_3)_2SiO_{2/2}$ units (D units) and 2.5 mol% of $(CH_2{=}CH)(CH_3)SiO_{2/2}$ units ($D^{Vi}$ units) and having Mn of 30,000, 30 parts by mass of dimethylpolysiloxane composed of 99.85 mol% of $(CH_3)_2SiO_{2/2}$ units (D units) and 0.15 mol% of $(CH_2{=}CH)(CH_3)SiO_{2/2}$ units ($D^{Vi}$ units) and having Mn of 60,000, and 200 parts by mass of toluene, a solution consisting of 50 parts by mass of vinylmethylpolysiloxane of resin structure composed of 50 mol% of $SiO_{4/2}$ units (Q units), 48 mol% of $(CH_3)_3SiO_{1/2}$ units (M units) and 2 mol% of $(CH_2{=}CH)(CH_3)_2SiO_{1/2}$ units ($M^{Vi}$ units) and having Mn of 7,000 and 100 parts by mass of toluene, a solution consisting of 25 parts by mass of organohydrogenpolysiloxane composed of 83.9 mol% of $(CH_3)_2SiO_{2/2}$ units (D units) and 16.1 mol% of $(CH_3)HSiO_{2/2}$ units ($D^H$ units) and having Mn of 2,400, 50 parts by mass of branched polysiloxane represented by the following formula (M-1), capped with a trimethylsiloxy group at a molecular chain end, and having a viscosity (25°C) of 50,000 mPa·s in a 30% by mass toluene solution and 120 parts by mass of toluene, and 0.6 parts by mass of 1-ethynylcyclohexanol were added and mixed. Furthermore, 0.4 parts by mass of a hydrosilylation reaction catalyst CAT-PL-5 (manufactured by Shin-Etsu Chemical Co., Ltd., platinum concentration of 1.0% by mass) was added thereto, and the mixture was filtered through a 0.2 μm membrane filter to prepare a thermosetting silicone resin solution (B-2). The viscosity of the resin solution (B-2) at 25°C was 2,900 mPa·s. The Si-H/Si-Vi (molar ratio) in Resin Solution Preparation Example 4 is 1.5.

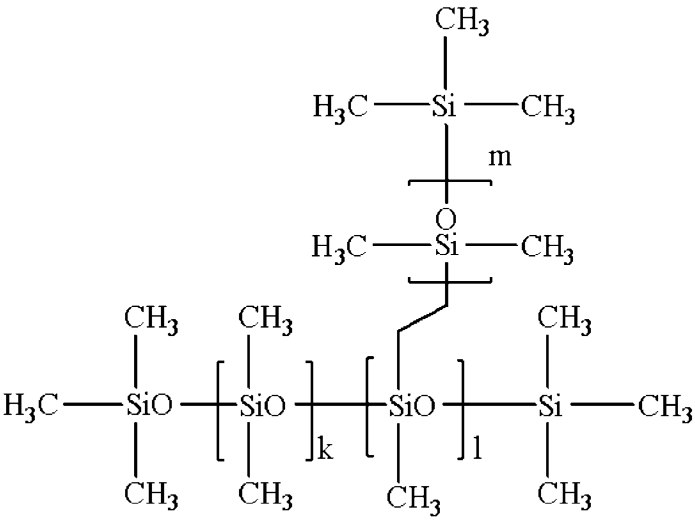

(M-1)

[Resin Solution Preparation Example 5]

To a solution consisting of 100 parts by mass of dimethylpolysiloxane composed of 97.5 mol% of $(CH_3)_2SiO_{2/2}$ units (D units) and 2.5 mol% of $(CH_2=CH)(CH_3)SiO_{2/2}$ units ($D^{Vi}$ units) and having Mn of 30,000 and 200 parts by mass of toluene, a solution consisting of 50 parts by mass of vinylmethylpolysiloxane composed of 50 mol% of $SiO_{4/2}$ units (Q units), 48 mol% of $(CH_3)_3SiO_{1/2}$ units (M units) and 2 mol% of $(CH_2=CH)(CH_3)_2SiO_{1/2}$ units ($M^{Vi}$ units) and having Mn of 7,000 and 100 parts by mass of toluene, a solution consisting of 15 parts by mass of organohydrogenpolysiloxane composed of 83.9 mol% of $(CH_3)_2SiO_{2/2}$ units (D units) and 16.1 mol% of $(CH_3)HSiO_{2/2}$ units ($D^H$ units) and having Mn of 2,400, 20 parts by mass of linear dimethylpolysiloxane capped with trimethylsiloxy groups at both molecular chain ends and having a viscosity (25°C) of 100,000 mPa·s in a 30% by mass toluene solution and 40 parts by mass of toluene, and 0.6 parts by mass of 1-ethynylcyclohexanol were added and mixed. Furthermore, 0.4 parts by mass of a hydrosilylation reaction catalyst CAT-PL-5 was added thereto, and the mixture was filtered through a 0.2 μm membrane filter to prepare a thermosetting silicone resin solution (B-3). The viscosity of the resin solution (B-3) at 25°C was 3,300 mPa·s. The Si-H/Si-Vi (molar ratio) in Resin Solution Preparation Example 5 is 0.7.

[Resin Solution Preparation Example 6]

To a solution consisting of 70 parts by mass of dimethylpolysiloxane composed of 97.5 mol% of $(CH_3)_2SiO_{2/2}$ units (D units) and 2.5 mol% of $(CH_2=CH)(CH_3)SiO_{2/2}$ units ($D^{Vi}$ units) and having Mn of 30,000, 30 parts by mass of dimethylpolysiloxane composed of 99.85 mol% of $(CH_3)_2SiO_{2/2}$ units (D units) and 0.15 mol% of $(CH_2=CH)(CH_3)SiO_{2/2}$ units ($D^{Vi}$ units) and having Mn of 60,000, and 200 parts by mass of toluene, a solution consisting of 50 parts by mass of vinylmethylpolysiloxane of resin structure composed of 50 mol% of $SiO_{4/2}$ units (Q units), 48 mol% of $(CH_3)_3SiO_{1/2}$ units (M units) and 2 mol% of $(CH_2=CH)(CH_3)_2SiO_{1/2}$ units ($M^{Vi}$ units) and having Mn of 7,000 and 100 parts by mass of toluene, a solution consisting of 21 parts by mass of organohydrogenpolysiloxane composed of 83.9 mol% of $(CH_3)_2SiO_{2/2}$ units (D units) and 16.1 mol% of $(CH_3)HSiO_{2/2}$ units ($D^H$ units) and having Mn of 2,400, 30 parts by mass of linear dimethylpolysiloxane capped with trimethylsiloxy groups at both molecular chain ends and having a viscosity (25°C) of 5,000 mPa·s in a 30% by mass toluene solution and 30 parts by mass of toluene, and 0.6 parts by mass of 1-ethynylcyclohexanol were added and mixed. Furthermore, 0.4 parts by mass of a hydrosilylation reaction catalyst CAT-PL-5 was added thereto, and the mixture was filtered through a 0.2 μm membrane filter to prepare a thermosetting silicone resin solution (B-4). The viscosity of the resin solution (B-4) at 25°C was 2,200 mPa·s. The Si-H/Si-Vi (molar ratio) in Resin Solution Preparation Example 6 is 1.2.

[Resin Solution Preparation Example 7]

To a solution consisting of 85 parts by mass of dimethylpolysiloxane composed of 98 mol% of $(CH_3)_2SiO_{2/2}$ units (D units) and 2.0 mol% of $(CH_2=CH)(CH_3)SiO_{2/2}$ units ($D^{Vi}$ units) and having Mn of 50,000, 15 parts by mass of methylpolysiloxane of resin structure composed of 56 mol% of $SiO_{4/2}$ units (Q units) and 44 mol% of $Me_3SiO_{1/2}$ units (M units) and having Mn of 6,000, and 400 parts by mass of toluene, 21 parts by mass of organohydrogenpolysiloxane composed of 100 mol% of $(CH_3)HSiO_{2/2}$ units ($D^H$ units) and having Mn of 3,000 and 0.7 parts by mass of 1-ethynylcyclohexanol were added and mixed. Furthermore, 0.5 parts by mass of platinum catalyst CAT-PL-5 (manufactured by Shin-Etsu Chemical Co., Ltd.) was added, and the mixture was filtered through a 0.2 μm membrane filter to prepare a thermosetting silicone resin solution (B-5). The viscosity of the resin solution (B-5) at 25°C was 70 mPa·s. The Si-H/Si-Vi (molar ratio) in Resin Solution Preparation Example 7 is 22.

[Resin Solution Preparation Example 8]

In a flask equipped with a stirrer, a thermometer, a nitrogen substitution apparatus, and a reflux condenser, 43.1 g of 9,9'-bis(3-allyl-4-hydroxyphenyl)fluorene, 29.5 g of organohydrogensiloxane represented by the (M-1) above, 135 g of toluene, and 0.04 g of chloroplatinic acid were charged, and the temperature was raised to 80°C. After that, 17.5 g of 1,4-bis(dimethylsilyl)benzene was added dropwise into the flask over one hour. At this time, the temperature inside the flask rose to 85°C. After completing the dripping and further aging at 80°C for 2 hours, toluene was distilled off and 80 g of cyclohexanone was added to obtain a resin solution with a resin solid concentration of 50% by mass using cyclohexanone as the solvent. The molecular weight of the resin component in this solution was measured by GPC and found to be a weight-average molecular weight of 45,000 in terms of polystyrene. Furthermore, to 50 g of this resin solution, 7.5 g of EOCN-1020 (produced by Nippon Kayaku Co., Ltd.), which is an epoxy cross-linking agent, was added as a cross-linking agent, 0.2 g of bis(tert-butylsulfonyl)diazomethane (BSDM) produced by FUJIFILM Wako Pure Chemical Corporation was added as a curing catalyst, and 0.1 g of tetrakis[methylene-(3,5-di-tert-butyl-4-hydroxyhydrocinnamate)]methane was added as an antioxidant. The mixture was then filtered through a 1 μm membrane filter to obtain a resin solution (C-1). The viscosity of the resin solution (C-1) at 25°C was 260 mPa·s.

[Examples 1 to 7, Comparative Examples 1 to 3, and Reference Examples 1 to 3]

Onto a 200 mm-diameter silicon wafer (thickness: 725 μm) in which a copper post with a height of 10 μm and a diameter of 40 μm was formed over the entire surface of the front side, and the entire surface of the wafer front side was coated with "polyimide film (PI film)", "SiN film", or "polybenzoxazole film (PBO film)" as shown in Table 1, a solution of a thermoplastic resin composition corresponding to the layer (A) was spin-coated and heated on a hot plate at 150°C for 5 minutes to form the layer (A) on the wafer bump-formed surface with the film thickness shown in Table 1. Meanwhile, a glass wafer with a diameter of 200 mm (thickness: 500 μm) was used as a support. Onto this support, a solution of the thermosetting siloxane composition corresponding to the layer (B) was spin-coated and heated on a hot plate at 100°C for 2 minutes to form the layer (B) on the support with the film thickness shown in Table 1. The silicon wafer with the PI film or the like including the thermoplastic resin layer (A) (surface-treated silicon wafer) and the glass wafer with the thermosetting siloxane polymer layer (B), both prepared as described above, were vacuum-bonded with their resin surfaces facing each other using a wafer bonding apparatus EVG520IS manufactured by EV Group at 100°C under a pressure of $10^{-3}$ mbar or less (i.e., under vacuum) with a load of 5 kN to produce a wafer processing body. It should be noted that, although a glass plate was used as a support to visually determine abnormalities after bonding of the substrate, a silicon substrate that does not transmit light, such as a wafer, can also be used.

Subsequently, the following tests were conducted on the obtained wafer processing body. The results are shown together in Table 1. Each test was conducted by the following method.

(1) Adhesion Test

The wafer processing body was heated at 180°C for 1 hour using an oven, then cooled to room temperature. Afterward, the adhesion condition of the wafer interface was visually checked. The case where no abnormalities such as bubbles occurred at the interface was evaluated as good and marked with a circle "◦", while the case where abnormalities occurred was evaluated as defective and marked with a cross "×".

(2) Backside Grinding Resistance Test

The wafer processing body was used to perform backside grinding of the silicon wafer with a diamond grinding wheel using a grinder (DAG-810 manufactured by DISCO Corporation). The grinding was performed until the thickness of the substrate reached 50 μm, and then an optical microscope (100×) was used to examine any abnormalities such as cracks or peels. The case where no abnormalities occurred was evaluated as good and marked with a circle "◦", while the case where abnormalities occurred was evaluated as defective and marked with a cross "×".

(3) CVD Resistance Test

The wafer processing body that had undergone the backside grinding resistance test (2) was introduced into a CVD apparatus and an experiment of forming 2 μm-$SiO_2$ film was conducted. The presence or absence of appearance

abnormalities was checked by visual observation. The case where no appearance abnormalities occurred was evaluated as good and marked with a circle "o", while the case where appearance abnormalities such as voids, wafer swelling, or wafer damage occurred was evaluated as defective and marked with a cross "×". The conditions for CVD resistance test are as follows.

Apparatus Name: PD270STL, Plasma CVD manufactured by Samco Inc.
RF500W, internal pressure 40 Pa
TEOS (tetraethyl orthosilicate): $O_2$ = 20 sccm: 680 sccm

(4) Peelability Test

To examine the peelability of the substrate, first, a dicing tape (ELP UB-3083D manufactured by Nitto Denko Corporation) was applied to the wafer side of the wafer processing body that had undergone the CVD resistance test (3) using a dicing frame, and the surface of this dicing tape was set on a suction plate through vacuum adsorption. Afterwards, the glass substrate was peeled off at room temperature, by lifting one point of the glass with tweezers. The case where a 50 μm thick wafer could be peeled off without cracking was marked with a circle "o", while the case where abnormalities such as cracking occurred was evaluated as defective and marked with a cross "×". In addition, the wafer after peeling was observed to determine between which layers the peeled interface was formed.

(5) Cleaning Removability Test

A wafer with 200 mm diameter after the peelability test (4), which had been mounted on the dicing frame via dicing tape (exposed to CVD resistance test conditions), was set onto a spin coater with the peeled surface facing up. Subsequently, p-menthane as the cleaning solvent was sprayed for 5 minutes. The wafer was then rinsed by spraying isopropyl alcohol (IPA) while rotating the wafer. Then, the appearance was observed, and the presence or absence of any remaining adhesive material was checked visually. Those with no remaining resin were evaluated as good and marked with a circle "o", while those with remaining resin were evaluated as defective and marked with a cross "×".

(6) Peel Strength Test

In Examples, with a 200 mm-diameter silicon wafer (thickness: 725 μm) in which the entire surface of the wafer front side was coated with "PI film", "SiN film", or "PBO film", a material corresponding to the layer (A) was spin-coated on the wafer and heated on a hot plate at 150°C for 5 minutes to form the layer (A) with the film thickness shown in Table 1. Subsequently, a solution of a thermosetting siloxane polymer corresponding to the layer (B) was spin-coated onto the layer (A) formed on the silicon wafer, and then heated on a hot plate at 100°C for 2 minutes to remove the solvent, thereby forming the layer (B) with the film thickness shown in Table 1. Subsequently, the layer (B) was cured in an oven at 180°C for 1 hour, then cooled to room temperature. Afterward, five pieces of polyimide tape, each having 150 mm in length and 25 mm in width, were applied onto the layer (B) on the wafer, and the temporary adhesive material layer in the areas not covered by the tapes was removed. The tape was peeled in a 180° peel from one end at 25°C and a speed of 300 mm/min over a distance of 120 mm using AUTOGRAPH (AG-1) manufactured by Shimadzu Corporation, and the average force exerted during the peeling (120 mm stroke × 5 times) was determined as the peel strength of the layer (B) .

In Comparative Examples and Reference Examples, a solution of a thermosetting siloxane polymer corresponding to the layer (B) was spin-coated onto the wafer, and then heated on a hot plate at 100°C for 2 minutes to remove the solvent, thereby forming the layer (B) with the film thickness shown in Table 1. Subsequently, the layer (B) was cured in an oven at 180°C for 1 hour, and then cooled to room temperature, and the peel strength was measured in the same manner as in Examples. The results are shown in Table 1.

(7) Measurement of Storage Modulus of Thermosetting Siloxane Polymer Layer (B)

In Examples, with a 200 mm-diameter silicon wafer (thickness: 725 μm) in which the entire surface of the wafer front side was coated with "PI film", "SiN film", or "PBO film", a material corresponding to layer (A) was spin-coated on the wafer and heated on a hot plate at 150°C for 5 minutes to form the layer (A) with the film thickness shown in Table 1. Subsequently, a solution of a thermosetting siloxane polymer corresponding to the layer (B) was spin-coated onto the layer (A) formed on the silicon wafer, and then heated on a hot plate at 100°C for 2 minutes to remove the solvent, thereby forming the layer (B) with the film thickness shown in Table 1. Subsequently, the layer (B) was cured in an oven at 180°C for 1 hour and then cooled to room temperature. The obtained substrate including the layer (A) and the layer (B) was sandwiched using a 25 mm-aluminum plate with a load of 50 gf applied to the layer (B) using an ARES G2 manufactured by TA Instruments. The value of storage modulus obtained from the modulus measurement at 25°C was considered the

storage modulus of the layer (B).

In Comparative Examples and Reference Examples, a solution of a thermosetting siloxane polymer corresponding to the layer (B) was spin-coated onto the wafer, and then heated on a hot plate at 100°C for 2 minutes to remove the solvent, thereby forming the layer (B) with the film thickness shown in Table 1. Subsequently, the layer (B) was cured in an oven at 180°C for 1 hour, cooled to room temperature, and the storage modulus of the layer (B) was measured in the same manner as in Examples. The results are shown in Table 1.

[Table 1]

| | | Example 1 | Example 2 | Example 3 | Example 4 | Example 5 | Example 6 | Example 7 | Comparative Example 1 | Comparative Example 2 | Comparative Example 3 | Reference Example 1 | Reference Example 2 | Reference Example 3 |
|---|---|---|---|---|---|---|---|---|---|---|---|---|---|---|
| Circuit-bearing wafer | Base material | Si | Si | Si | Si | Si | Si | Si | Si | Si | Si | Si | Si | Si |
| | Surface treatment | PI film | PI film | PI film | SiN film | SiN film | SiN film | PBO film | PI film | SiN film | PBO film | - | - | - |
| Resin layer (A) | | A-1 | A-2 | A-1 | A-1 | A-2 | A-1 | A-2 | - | - | - | - | - | - |
| Layer (A) film thickness (μm) | | 5 | 6 | 4 | 5 | 5 | 5 | 6 | - | - | - | - | - | - |
| Support | | Glass | Glass | Glass | Glass | Glass | Glass | Glass | Glass | Glass | Glass | Glass | Glass | Glass |
| Resin layer (B) | | B-1 | B-2 | B-3 | B-1 | B-2 | B-3 | B-2 | B-1 | B-2 | B-2 | B-1 | B-2 | B-3 |
| Layer (B) film thickness (μm) | | 53 | 59 | 55 | 52 | 59 | 54 | 60 | 51 | 58 | 59 | 50 | 60 | 50 |
| Layer (B) peel strength (gf) | | 110 | 180 | 80 | 120 | 160 | 70 | 190 | 8 | 7 | 800 | 130 | 200 | 100 |
| Layer (B) film modulus (Pa) | | $0.30\times10^{5}$ | $0.12\times10^{5}$ | $1.10\times10^{6}$ | $0.28\times10^{5}$ | $0.10\times10^{5}$ | $1.08\times10^{6}$ | $0.13\times10^{5}$ | $0.25\times10^{5}$ | $0.09\times10^{5}$ | $0.07\times10^{5}$ | $0.32\times10^{5}$ | $0.15\times10^{5}$ | $1.16\times10^{6}$ |
| Adhesion | | ○ | ○ | ○ | ○ | ○ | ○ | ○ | ○ | ○ | ○ | ○ | ○ | ○ |
| Backside grinding resistance | | ○ | ○ | ○ | ○ | ○ | ○ | ○ | × After grinding, peeling of circuit-bearing wafer was observed | × After grinding, peeling of circuit-bearing wafer was observed | ○ | ○ | ○ | ○ |
| CVD resistance | | ○ | ○ | ○ | ○ | ○ | ○ | ○ | - | - | ○ | ○ | ○ | ○ |
| Peelability | | ○ | ○ | ○ | ○ | ○ | ○ | ○ | - | - | × Peeling failed | ○ | ○ | ○ |
| Peeled surface | | Layer (A)/ layer (B) interface | Layer (A)/ layer (B) interface | Layer (A)/ layer (B) interface | Layer (A)/ layer (B) interface | Layer (A)/ layer (B) interface | Layer (A)/ layer (B) interface | Layer (A)/ layer (B) interface | - | - | × Peeling failed | Circuit-bearing wafer/ layer (B) interface | Circuit-bearing wafer/ layer (B) interface | Circuit-bearing wafer/ layer (B) interface |

(continued)

| | Example 1 | Example 2 | Example 3 | Example 4 | Example 5 | Example 6 | Example 7 | Comparative Example 1 | Comparative Example 2 | Comparative Example 3 | Reference Example 1 | Reference Example 2 | Reference Example 3 |
|---|---|---|---|---|---|---|---|---|---|---|---|---|---|
| Cleaning removability | ○ | ○ | ○ | ○ | ○ | ○ | ○ | - | - | - | × | × | × |

As shown in Table 1, in Examples in which a wafer processing body was produced by forming a thermoplastic resin layer (A) on a circuit-bearing substrate that had been surface-treated in advance, and then bonding with a support on which a thermosetting siloxane polymer layer (B) was formed, stable and satisfactory adhesion, wafer processability, peelability, and cleaning removability were achieved irrespective of the type of surface treatment. In Comparative Examples where the thermoplastic resin layer (A) was not provided between the circuit-bearing substrate which was surface-treated in advance and the thermosetting siloxane polymer layer (B), errors occurred depending on the type of the surface treatment of the substrate such as peeling during wafer processing or inability to peeling during the wafer peeling step. In Reference Examples using a bare silicon wafer without surface treatment, there were no significant issues in terms of adhesion, wafer processability, and peelability even without providing the thermoplastic resin layer (A), but residues were observed in terms of cleaning removability. From this, it was confirmed that the cleaning removability was also improved in Examples in which the thermoplastic resin layer (A) was provided.

[Examples 8 to 10]

Onto a 200 mm-diameter silicon wafer (thickness: 725 μm) in which a copper post with a height of 10 μm and a diameter of 40 μm was formed over the entire surface of the front side, and the entire surface of the wafer front side was coated with "PI film", "SiN film", or "PBO film", a solution of a thermoplastic resin composition corresponding to the layer (A) was first spin-coated and heated on a hot plate at 150°C for 5 minutes to form the layer (A) on the wafer bump-formed surface with the film thickness shown in Table 2. Subsequently, the film was cooled to room temperature, and then a solution of the thermosetting siloxane composition corresponding to the layer (B) was spin-coated onto the layer (A) and heated on a hot plate at 100°C for 2 minutes to form the layer (B) on the layer (A) with the film thickness shown in Table 2. The silicon wafer with the thermosetting siloxane polymer layer (B) and the thermoplastic resin layer (A) and the support glass wafer, both prepared as described above, were vacuum-bonded using a wafer bonding apparatus EVG520IS manufactured by EV Group at 100°C under a pressure of $10^{-3}$ mbar or less (i.e., under vacuum) with a load of 5 kN to produce a wafer processing body. It should be noted that, although a glass wafer was used as a support to visually determine abnormalities after the substrate bonding, a silicon substrate that does not transmit light such as a wafer can also be used.

[Comparative Example 4]

Onto a 200 mm-diameter silicon wafer (thickness: 725 μm) in which a copper post with a height of 10 μm and a diameter of 40 μm was formed over the entire surface of the front side, and the entire surface of the wafer front side was coated with "PI film", a thermoplastic resin solution (A-1) corresponding to the layer (A) was first spin-coated and heated on a hot plate at 150°C for 5 minutes to form a layer (A) on the wafer bump-formed surface with the film thickness shown in Table 2. Subsequently, the film was cooled to room temperature, and then a thermosetting silicone resin solution (B-5) corresponding to the layer (B) was spin-coated onto the layer (A) and heated on a hot plate at 150°C for 3 minutes and further in an oven at 180°C for 1 hour to form the layer (B) on the layer (A) with the film thickness shown in Table 2. Next, a resin solution (C-1) was spin-coated onto the glass wafer of the support, and heated on a hot plate at 150°C for 3 minutes to form a layer (C) on the glass wafer of the support with the film thickness shown in Table 2. The silicon wafer with the thermosetting siloxane polymer layer (B) and the thermoplastic resin layer (A) and the glass wafer with the resin film (C), both prepared as described above, were vacuum-bonded using a wafer bonding apparatus EVG520IS manufactured by EV Group at 120°C under a pressure of $10^{-3}$ mbar or less (i.e., under vacuum) with a load of 5 kN to produce a wafer processing body. It should be noted that, although a glass wafer was used as a support to visually determine abnormalities after bonding of the substrate, a silicon substrate that does not transmit light such as a wafer can also be used.

Items other than the peel strength test and the film modulus measurement were evaluated using the same procedure as above. The results are shown in Table 2.

[Table 2]

| | | Example 8 | Example 9 | Example 10 | Comparative Example 4 |
|---|---|---|---|---|---|
| Circuit-bearing wafer | Base material | Si | Si | Si | Si |
| | Surface treatment | PI film | SiN film | PBO film | PI film |
| Resin laver (A) | | A-1 | A-1 | A-1 | A-1 |
| Layer (A) film thickness (μm) | | 5 | 5 | 5 | 6 |

(continued)

| | Example 8 | Example 9 | Example 10 | Comparative Example 4 |
|---|---|---|---|---|
| Resin laver (B) | B-4 | B-4 | B-4 | B-5 |
| Layer (B) film thickness (μm) | 55 | 57 | 56 | 20 |
| Resin laver (C) | - | - | - | C-1 |
| Layer (C) film thickness (μm) | - | - | - | 50 |
| Support | Glass | Glass | Glass | Glass |
| Adhesion | ○ | ○ | ○ | ○ |
| Backside grinding resistance | ○ | ○ | ○ | ○ |
| CVD resistance | ○ | ○ | ○ | ○ |
| Peelability | ○ | ○ | ○ | ○ |
| Peeled surface | Layer (A) / layer (B) interface | Layer (A) / layer (B) interface | Layer (A) / layer (B) interface | Layer (B)/ layer (C) interface |
| Cleaning removability | ○ | ○ | ○ | × |

It was confirmed that, as shown in Table 2, in Examples 8 to 10 in which a wafer processing body was produced by forming a thermoplastic resin layer (A) and a thermosetting siloxane polymer layer (B) on a circuit-bearing substrate that had been surface-treated in advance and then bonding with a support, stable and satisfactory adhesion, wafer processability, peelability, and cleaning removability were achieved irrespective of the surface treatment of a circuit-bearing substrate, similarly to Examples 1 to 7. In Comparative Example 4, in which temporary adhesive material layer consists of three layers of the layer (A), the layer (B), and the layer (C), the peeled interface was the interface between the layer (B) and the layer (C). As a result, the layer (B) remained thick on the circuit-bearing wafer side, leading to inferior cleaning removability.

The present description includes the following embodiments.

[1]: A temporary adhesive material for wafer processing, used for temporarily bonding a support and a wafer having a circuit-forming surface on a front side and a backside to be processed, including a composite temporary adhesive material layer having a two-layered structure that includes

a first temporary adhesive layer including a thermoplastic resin layer (A) capable of peelably adhering to the front side of the wafer, and
a second temporary adhesive layer including a thermosetting siloxane polymer layer (B) laminated on the first temporary adhesive layer.

[2]: The temporary adhesive material for wafer processing according to the above [1], wherein the thermosetting siloxane polymer layer (B) is a cured layer of a thermosetting siloxane composition containing

(B-1) organopolysiloxane having two or more alkenyl groups in one molecule in an amount of 100 parts by mass,
(B-2) organohydrogenpolysiloxane containing two or more silicon atom-bonded hydrogen atoms (Si-H groups) in one molecule in an amount such that a molar ratio of the Si-H group in component (B-2) to the alkenyl group in the component (B-1) is 0.3 to 10,
(B-3) non-functional organopolysiloxane in an amount of 0.1 to 200 parts by mass, and
(B-4) a hydrosilylation reaction catalyst in an amount of 0.1 to 5,000 ppm in terms of metal atom amount based on a total mass of the components (B-1), (B-2), and (B-3).

[3]: The temporary adhesive material for wafer processing according to the above [2], wherein the thermosetting siloxane composition further contains a hydrosilylation reaction control agent as component (B-5), and an amount of the component (B-5) added is 0.0001 to 50 parts by mass based on the total mass of the components (B-1), (B-2), and

(B-3).

[4]: The temporary adhesive material for wafer processing according to the above [1] or [2], wherein the non-functional organopolysiloxane as the component (B-3) consists of dimethylpolysiloxane and has a viscosity of 100 to 500,000 mPa·s at 25°C in a 30% by mass toluene solution.

[5]: The temporary adhesive material for wafer processing according to any of the above [1] to [4], wherein the thermosetting siloxane polymer layer (B) has, after curing, a 180° peel strength of 2 gf (0.020 N) or more and 500 gf (4.9 N) or less when tested with a 25 mm-wide test piece against the thermoplastic resin layer (A) at 25°C.

[6]: The temporary adhesive material for wafer processing according to any of the above [1] to [5], wherein the thermosetting siloxane polymer layer (B) has, after curing, a storage modulus of 1,000 Pa or more and 1,000 MPa or less at 25°C.

[7]: The temporary adhesive material for wafer processing according to any of the above [1] to [6], wherein the thermoplastic resin layer (A) is a non-silicone resin.

[8]: The temporary adhesive material for wafer processing according to any of the above [1] to [7], which is used for temporarily bonding the support and the wafer in which the circuit-forming surface is surface-treated with a material different from a base material of the wafer.

[9]: A method for producing a thin wafer, including the steps of:

(a) when bonding a support and a circuit-forming surface of a wafer having the circuit-forming surface on a front side and a non-circuit-forming surface on a backside via the temporary adhesive material for wafer processing according to any of the above [1] to [8], forming the thermosetting siloxane polymer layer (B) on the support, and then bonding the obtained support and the wafer in which the thermoplastic resin layer (A) is formed on the circuit-forming surface under vacuum;
(b) thermally curing the polymer layer (B);
(c) grinding or polishing the non-circuit-forming surface of the wafer bonded with the support;
(d) processing the non-circuit-forming surface of the wafer; and
(e) peeling the processed wafer from the support.

[10]: A method for producing a thin wafer, including the steps of:

(a) when bonding a support and a circuit-forming surface of a wafer having the circuit-forming surface on a front side and a non-circuit-forming surface on a backside via the temporary adhesive material for wafer processing according to any of the above [1] to [8], first forming the thermoplastic resin layer (A) on the circuit-forming surface of the wafer, subsequently forming the thermosetting siloxane polymer layer (B) on the thermoplastic resin layer (A), and then bonding the support and the obtained wafer under vacuum;
(b) thermally curing the polymer layer (B);
(c) grinding or polishing the non-circuit-forming surface of the wafer bonded with the support;
(d) processing the non-circuit-forming surface of the wafer; and
(e) peeling the processed wafer from the support.

[11]: A wafer processing body including: a support; a temporary adhesive material layer formed on the support; and a wafer laminated on the temporary adhesive material layer and having a circuit surface on a front side and a backside to be processed, wherein

the temporary adhesive material layer includes a composite temporary adhesive material layer having a two-layered structure that includes a first temporary adhesive layer including a thermoplastic resin layer (A) peelably adhered to the front side of the wafer, and a second temporary adhesive layer including a thermosetting siloxane polymer layer (B) laminated on the first temporary adhesive layer.

[12]: The wafer processing body according to the above [11], wherein the thermosetting siloxane polymer layer (B) is a cured layer of a thermosetting siloxane composition containing

(B-1) organopolysiloxane having two or more alkenyl groups in one molecule in an amount of 100 parts by mass,
(B-2) organohydrogenpolysiloxane containing two or more silicon atom-bonded hydrogen atoms (Si-H groups) in one molecule in an amount such that a molar ratio of the Si-H group in component (B-2) to the alkenyl group in the component (B-1) is 0.3 to 10,
(B-3) non-functional organopolysiloxane in an amount of 0.1 to 200 parts by mass, and
(B-4) a hydrosilylation reaction catalyst in an amount of 0.1 to 5,000 ppm in terms of metal atom amount based on a total mass of the components (B-1), (B-2), and (B-3).

[13]: The wafer processing body according to the above [12], wherein the thermosetting siloxane composition further

contains a hydrosilylation reaction control agent as component (B-5), and an amount of the component (B-5) added is 0.0001 to 50 parts by mass based on the total mass of the components (B-1), (B-2), and (B-3).
[14]: The wafer processing body according to the above [12] or [13], wherein the non-functional organopolysiloxane as the component (B-3) consists of dimethylpolysiloxane and has a viscosity of 100 to 500,000 mPa·s at 25°C in a 30% by mass toluene solution.
[15]: The wafer processing body according to any of the above [11] to [14], wherein the thermosetting siloxane polymer layer (B) has, after curing, a 180° peel strength of 2 gf (0.020 N) or more and 500 gf (4.9 N) or less when tested with a 25 mm-wide test piece against the thermoplastic resin layer (A) at 25°C.
[16]: The wafer processing body according to any of the above [11] to [15], wherein the thermosetting siloxane polymer layer (B) has, after curing, a storage modulus of 1,000 Pa or more and 1,000 MPa or less at 25°C.
[17]: The wafer processing body according to any of the above [11] to [16], wherein the wafer is a wafer in which the circuit-forming surface is surface-treated with a material different from a base material of the wafer.

It should be noted that the present invention is not limited to the embodiments described above. The above embodiments are illustrative, and any one that has substantially the same configurations and produces the same effects and advantages as the technical idea described in the claims of the present invention is included within the technical scope of the present invention.

## Claims

1. A temporary adhesive material for wafer processing, used for temporarily bonding a support and a wafer having a circuit-forming surface on a front side and a backside to be processed, comprising a composite temporary adhesive material layer having a two-layered structure that includes

   a first temporary adhesive layer including a thermoplastic resin layer (A) capable of peelably adhering to the front side of the wafer, and
   a second temporary adhesive layer including a thermosetting siloxane polymer layer (B) laminated on the first temporary adhesive layer.

2. The temporary adhesive material for wafer processing according to claim 1, wherein the thermosetting siloxane polymer layer (B) is a cured layer of a thermosetting siloxane composition containing

   (B-1) organopolysiloxane having two or more alkenyl groups in one molecule in an amount of 100 parts by mass,
   (B-2) organohydrogenpolysiloxane containing two or more silicon atom-bonded hydrogen atoms (Si-H groups) in one molecule in an amount such that a molar ratio of the Si-H group in component (B-2) to the alkenyl group in the component (B-1) is 0.3 to 10,
   (B-3) non-functional organopolysiloxane in an amount of 0.1 to 200 parts by mass, and
   (B-4) a hydrosilylation reaction catalyst in an amount of 0.1 to 5,000 ppm in terms of metal atom amount based on a total mass of the components (B-1), (B-2), and (B-3).

3. The temporary adhesive material for wafer processing according to claim 2, wherein the thermosetting siloxane composition further contains a hydrosilylation reaction control agent as component (B-5), and an amount of the component (B-5) added is 0.0001 to 50 parts by mass based on the total mass of the components (B-1), (B-2), and (B-3).

4. The temporary adhesive material for wafer processing according to claim 2, wherein the non-functional organopolysiloxane as the component (B-3) consists of dimethylpolysiloxane and has a viscosity of 100 to 500,000 mPa·s at 25°C in a 30% by mass toluene solution.

5. The temporary adhesive material for wafer processing according to claim 1, wherein the thermosetting siloxane polymer layer (B) has, after curing, a 180° peel strength of 2 gf (0.020 N) or more and 500 gf (4.9 N) or less when tested with a 25 mm-wide test piece against the thermoplastic resin layer (A) at 25°C.

6. The temporary adhesive material for wafer processing according to claim 1, wherein the thermosetting siloxane polymer layer (B) has, after curing, a storage modulus of 1,000 Pa or more and 1,000 MPa or less at 25°C.

7. The temporary adhesive material for wafer processing according to claim 1, wherein the thermoplastic resin layer (A)

is a non-silicone resin.

8. The temporary adhesive material for wafer processing according to claim 1, which is used for temporarily bonding the support and the wafer in which the circuit-forming surface is surface-treated with a material different from a base material of the wafer.

9. A method for producing a thin wafer, comprising the steps of:

(a) when bonding a support and a circuit-forming surface of a wafer having the circuit-forming surface on a front side and a non-circuit-forming surface on a backside via the temporary adhesive material for wafer processing according to any one of claims 1 to 8, forming the thermosetting siloxane polymer layer (B) on the support, and then bonding the obtained support and the wafer in which the thermoplastic resin layer (A) is formed on the circuit-forming surface under vacuum;
(b) thermally curing the polymer layer (B);
(c) grinding or polishing the non-circuit-forming surface of the wafer bonded with the support;
(d) processing the non-circuit-forming surface of the wafer; and
(e) peeling the processed wafer from the support.

10. A method for producing a thin wafer, comprising the steps of:

(a) when bonding a support and a circuit-forming surface of a wafer having the circuit-forming surface on a front side and a non-circuit-forming surface on a backside via the temporary adhesive material for wafer processing according to any one of claims 1 to 8, first forming the thermoplastic resin layer (A) on the circuit-forming surface of the wafer, subsequently forming the thermosetting siloxane polymer layer (B) on the thermoplastic resin layer (A), and then bonding the support and the obtained wafer under vacuum;
(b) thermally curing the polymer layer (B);
(c) grinding or polishing the non-circuit-forming surface of the wafer bonded with the support;
(d) processing the non-circuit-forming surface of the wafer; and
(e) peeling the processed wafer from the support.

11. A wafer processing body comprising: a support; a temporary adhesive material layer formed on the support; and a wafer laminated on the temporary adhesive material layer and having a circuit surface on a front side and a backside to be processed, wherein
the temporary adhesive material layer includes a composite temporary adhesive material layer having a two-layered structure that includes a first temporary adhesive layer including a thermoplastic resin layer (A) peelably adhered to the front side of the wafer, and a second temporary adhesive layer including a thermosetting siloxane polymer layer (B) laminated on the first temporary adhesive layer.

12. The wafer processing body according to claim 11, wherein the thermosetting siloxane polymer layer (B) is a cured layer of a thermosetting siloxane composition containing

(B-1) organopolysiloxane having two or more alkenyl groups in one molecule in an amount of 100 parts by mass,
(B-2) organohydrogenpolysiloxane containing two or more silicon atom-bonded hydrogen atoms (Si-H groups) in one molecule in an amount such that a molar ratio of the Si-H group in component (B-2) to the alkenyl group in the component (B-1) is 0.3 to 10,
(B-3) non-functional organopolysiloxane in an amount of 0.1 to 200 parts by mass, and
(B-4) a hydrosilylation reaction catalyst in an amount of 0.1 to 5,000 ppm in terms of metal atom amount based on a total mass of the components (B-1), (B-2), and (B-3).

13. The wafer processing body according to claim 12, wherein the thermosetting siloxane composition further contains a hydrosilylation reaction control agent as component (B-5), and an amount of the component (B-5) added is 0.0001 to 50 parts by mass based on the total mass of the components (B-1), (B-2), and (B-3).

14. The wafer processing body according to claim 12, wherein the non-functional organopolysiloxane as the component (B-3) consists of dimethylpolysiloxane and has a viscosity of 100 to 500,000 mPa·s at 25°C in a 30% by mass toluene solution.

15. The wafer processing body according to any one of claims 11 to 14, wherein the thermosetting siloxane polymer layer

(B) has, after curing, a 180° peel strength of 2 gf (0.020 N) or more and 500 gf (4.9 N) or less when tested with a 25 mm-wide test piece against the thermoplastic resin layer (A) at 25°C.

**16.** The wafer processing body according to any one of claims 11 to 14, wherein the thermosetting siloxane polymer layer (B) has, after curing, a storage modulus of 1,000 Pa or more and 1,000 MPa or less at 25°C.

**17.** The wafer processing body according to any one of claims 11 to 14, wherein the wafer is a wafer in which the circuit-forming surface is surface-treated with a material different from a base material of the wafer.

[FIG. 1]

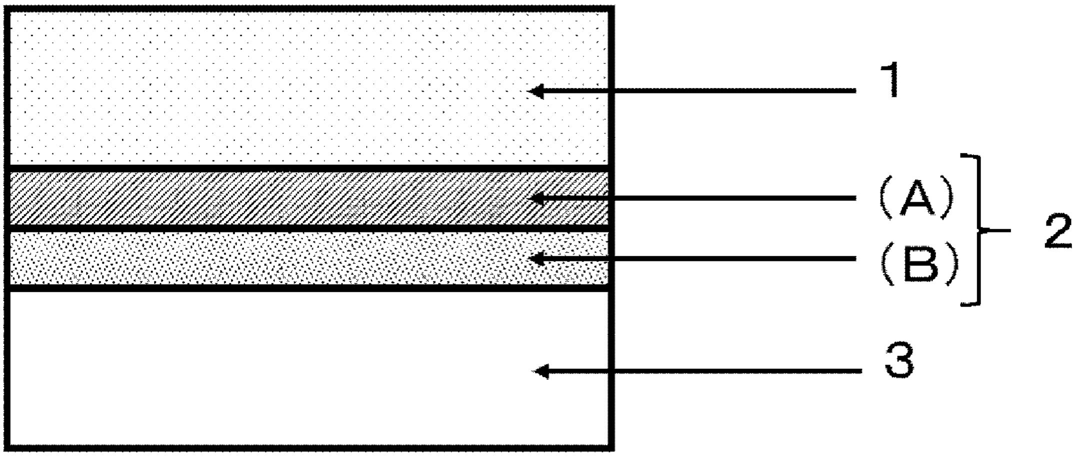

**INTERNATIONAL SEARCH REPORT**

International application No. **PCT/JP2024/008855**

**A. CLASSIFICATION OF SUBJECT MATTER**

***H01L 21/304***(2006.01)i; ***C09J 11/06***(2006.01)i; ***C09J 183/04***(2006.01)i; ***C09J 183/05***(2006.01)i; ***C09J 183/07***(2006.01)i; ***C09J 201/00***(2006.01)i

FI: H01L21/304 622J; H01L21/304 631; C09J183/04; C09J201/00; C09J183/05; C09J183/07; C09J11/06

According to International Patent Classification (IPC) or to both national classification and IPC

**B. FIELDS SEARCHED**

Minimum documentation searched (classification system followed by classification symbols)

H01L21/304; C09J11/06; C09J183/04; C09J183/05; C09J183/07; C09J201/00

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2021-14507 A (SHIN-ETSU CHEMICAL CO., LTD.) 12 February 2021 (2021-02-12) paragraphs [0019]-[0111], fig. 1 | 1, 7-11, 17 |
| Y | | 2-6, 12-16 |
| Y | WO 2021/112070 A1 (SHIN-ETSU CHEMICAL CO., LTD.) 10 June 2021 (2021-06-10) paragraphs [0007]-[0010] | 2-6, 12-16 |
| A | JP 2017-73541 A (SHIN-ETSU CHEMICAL CO., LTD.) 13 April 2017 (2017-04-13) entire text, all drawings | 1-17 |
| A | WO 2021/065547 A1 (SHIN-ETSU CHEMICAL CO., LTD.) 08 April 2021 (2021-04-08) entire text, all drawings | 1-17 |

☐ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **15 May 2024** | **28 May 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (July 2022)

**INTERNATIONAL SEARCH REPORT**
**Information on patent family members**

International application No.
**PCT/JP2024/008855**

| Patent document cited in search report | Publication date (day/month/year) | Patent family member(s) | Publication date (day/month/year) |
|---|---|---|---|
| JP 2021-14507 A | 12 February 2021 | US 2022/0372353 A1<br>paragraphs [0006]-[0131], fig. 1<br>EP 3998317 A1<br>CN 114096633 A<br>KR 10-2022-0032547 A<br>TW 202140282 A | |
| WO 2021/112070 A1 | 10 June 2021 | US 2023/0002647 A1<br>paragraphs [0009]-[0022]<br>EP 4071223 A1<br>KR 10-2022-0108799 A<br>CN 114868232 A<br>TW 202134386 A | |
| JP 2017-73541 A | 13 April 2017 | US 2017/0101555 A1<br>entire text, all drawings<br>EP 3154080 A1<br>KR 10-2017-0042237 A<br>CN 106992133 A<br>TW 201726865 A | |
| WO 2021/065547 A1 | 08 April 2021 | US 2022/0352001 A1<br>entire text, all drawings<br>EP 4039765 A1<br>CN 114521211 A<br>KR 10-2022-0075215 A<br>TW 202130776 A | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2004064040 A
- JP 2006328104 A
- US 7541264 B
- JP 2016122730 A